(19) Europäisches Patentamt
European Patent Office
Office européen des brevets

(11) **EP 4 618 162 A1**

(12) **EUROPEAN PATENT APPLICATION**
published in accordance with Art. 153(4) EPC

(43) Date of publication:
**17.09.2025 Bulletin 2025/38**

(21) Application number: **23888302.9**

(22) Date of filing: **09.08.2023**

(51) International Patent Classification (IPC):
***H01L 31/0224*** *(2006.01)* ***H01B 1/22*** *(2006.01)*

(52) Cooperative Patent Classification (CPC):
**H01B 1/22; H10F 77/20**

(86) International application number:
**PCT/JP2023/029078**

(87) International publication number:
**WO 2024/100947 (16.05.2024 Gazette 2024/20)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 07.11.2022 JP 2022178203
27.03.2023 PCT/JP2023/012085
13.06.2023 JP 2023096794

(71) Applicant: **Namics Corporation**
**Niigata-shi, Niigata 950-3131 (JP)**

(72) Inventors:
• **KONNO, Seiya**
**Niigata-shi, Niigata 950-3131 (JP)**
• **TANABE, Hideo**
**Niigata-shi, Niigata 950-3131 (JP)**
• **SAITO, Genki**
**Niigata-shi, Niigata 950-3131 (JP)**

(74) Representative: **Hoffmann Eitle**
**Patent- und Rechtsanwälte PartmbB**
**Arabellastraße 30**
**81925 München (DE)**

(54) **SOLAR CELL**

(57) A high-efficiency crystalline silicon solar cell having high open circuit voltage (Voc) and fill factor (FF) is provided.

Provided is a solar cell comprising: a crystalline silicon substrate comprising an impurity diffusion layer; a passivation film disposed on at least a part of the impurity diffusion layer of the substrate; and an electrode comprising silver (Ag), wherein the solar cell further comprises at least one AgSi region disposed in at least a portion between the electrode and the substrate, the AgSi region comprises at least one AgSi region having a depth of 100 nm or more, and a remaining ratio of the passivation film, which is a ratio of a length of the passivation film remaining in a scanning electron microscope photograph of a $5.7\ \mu\text{m} \times 3.9\ \mu\text{m}$ cross-section comprising the AgSi region of the solar cell, is 10 to 90%.

Fig. 7

EP 4 618 162 A1

**Description**

FIELD OF THE INVENTION

The present invention relates to a crystalline silicon solar cell using a crystalline silicon substrate.

BACKGROUND ART

In a semiconductor device such as a crystalline silicon solar cell using a crystalline silicon as a substrate that is obtained by processing a single crystalline silicon or a polycrystalline silicon into a flat plate, an electrode is typically formed on a surface of the silicon substrate using a conductive paste for forming the electrode for electrical contact with outside of the device. Among semiconductor devices in which the electrodes are formed in such a way, the production of crystalline silicon solar cells has greatly increased in recent years. These solar cells have an impurity diffusion layer, an antireflection film (a passivation film), and a light incident side surface-electrode on one surface of a crystalline silicon substrate, and a back side electrode on the other surface. By means of the light incident side surface-electrode and the back side electrode, the electric power generated by the crystalline silicon solar cell can be extracted to outside.

A conductive paste containing conductive powder, a glass frit, an organic binder, a solvent, and other additives is used for forming an electrode of a conventional crystalline silicon solar cell. Silver particles (silver powder) are mainly used as the conductive powder.

Patent Document 1 describes a method of manufacturing crystalline silicon solar cell. Patent Document 1 describes use of a conductive paste for forming an electrode containing inorganic materials for forming an electrode of crystalline silicon solar cell. Patent Document 1 describes that the inorganic materials consist of conductive particles and glass frits.

Patent Document 2 describes a process for improving the ohmic-contact behavior between a contact grid and an emitter layer in a silicon solar cell.

Specifically, the process of Patent Document 2 describes a predetermined voltage is applied directed contrary to the forward direction of the silicon solar cell, a point light source is guided over the sun-facing side of the silicon solar cell and thereby a section of a subsection of the sun-facing side is illuminated.

Patent Document 3 describes a conductive composition comprising a glass powder containing silver powder and PbO and a vehicle consisting of an organic substance for forming an electrode of a solar cell. Patent Document 3 describes that the conductive composition is a conductive composition for forming an electrode which penetrates a silicon nitride layer and is conductive to an n-type semiconductor layer formed under the silicon nitride layer. Patent Document 3 also describes that the basicity of the glass powder contained in the conductive composition is 0.6 to 0.8, and a transition point of the glass is 300 degree C to 450 degree C.

Prior Art Documents

Patent Documents

   Patent document 1: JP 2011-86754 A
   Patent document 2: JP 2021-513218 A
   Patent document 3: JP 2009-231826 A

DISCLOSURE OF THE INVENTION

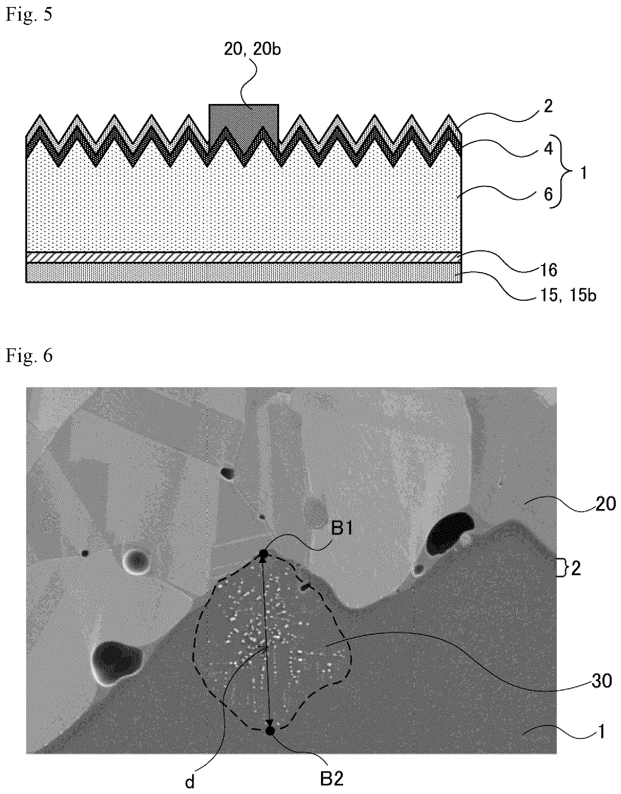

Fig. 5 shows an example of a cross-sectional schematic diagram of a typical crystalline silicon solar cell. As shown in Fig. 5, in a typical crystalline silicon solar cell, an electrode pattern of a light incident side surface-electrode 20 a (a surface electrode) is printed on a passivation film 2 which functions as the passivation film 2 using a conductive paste by screen printing method, etc., and the conductive paste is dried and fired at a predetermined temperature to form the light incident side surface-electrode 20. In a typical crystalline silicon solar cell, during the firing at the predetermined temperature, the conductive paste fires through the passivation film 2. This fire through allows the light incident side surface-electrode 20 to be formed in contact with the impurity diffusion layer 4. The fire through means that the passivation film 2 which is an insulating film is etched with a glass frit or the like contained in the conductive paste to form electrical continuity between the light incident side surface-electrode 20 and the impurity diffusion layer 4. In the example shown in Fig. 5, during the firing of the electrode pattern, the electrode pattern fires through the passivation film 2, so that the passivation film 2 disappears and the light incident side surface-electrode 20, and the impurity diffusion layer 4 come into contact with each other. A p-n junction is formed at the interface between the n-type crystalline silicon substrate 1 and the impurity diffusion layer 4. The majority portion of the incident light entering the crystalline silicon solar cell passes through the passivation film 2 and the impurity diffusion layer 4 and enters the n-type crystalline silicon substrate 1. In this process, light is absorbed in the n-type crystalline silicon substrate 1, and electron-hole pairs are generated. These electron-hole pairs are such that electrons are separated from the n-type crystalline silicon substrate 1 to the back side electrode 15, and holes are separated from the p-type impurity diffusion layer 4 to the light incident side surface-electrode 20 by the electric field due to the p-n junction. The electrons and holes (carriers) are taken out as electric current through these electrodes.

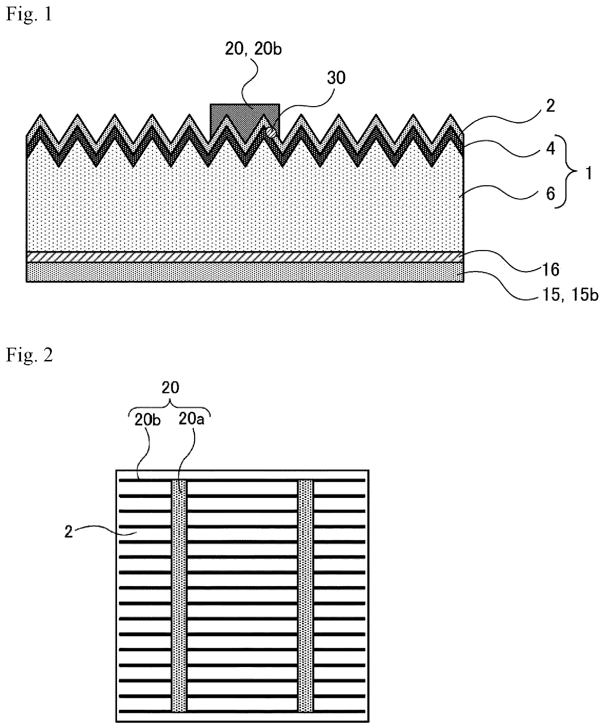

Fig. 2 shows an example of a schematic diagram of a light incident side surface of a crystalline silicon solar cell. As shown in Fig. 2, a bus bar electrode (a light incident side bus bar electrode 20a) and a light incident side finger electrode 20b (it may simply be referred to as "a finger electrode 20b".) are arranged as a light incident side surface-electrode 20 on the light incident side surface of the crystalline silicon solar cell. In the examples shown in Fig. 5 and Fig. 2, electrons among electron-hole pairs generated by incident light entering the crystalline silicon solar cell are collected by the finger electrode 20b and then collected by the light incident side bus bar electrode 20a. A metal ribbon covered with solder for interconnection is soldered to the light incident side bus bar electrode 20a, and the electric current is taken out by the metal ribbon.

The photo-electric conversion efficiency (it is sometimes simply referred to as "conversion efficiency".) of a solar cell is expressed as the product of fill factor (FF), open circuit voltage (Voc), and short circuit current (Jsc). Basically, there is a trade-off between fill factor (FF) and open circuit voltage (Voc), and it is difficult to increase both fill factor and open circuit voltage simultaneously.

In order to obtain a crystalline solar cell with high conversion efficiency, a low contact resistance between the light incident side surface-electrode 20 and the impurity diffusion layer 4 is required.

In the case of a conventional crystalline silicon solar cell, when forming light incident side surface-electrode 20, an electrode pattern of a conductive paste is fired, and fired through a passivation film 2, and it is brought into contact with an impurity diffusion layer 4. During this fire through, the impurity diffusion layer 4 is damaged, and a performance of a crystalline silicon solar cell (especially open circuit voltage (Voc)) is degraded.

As described above, it is generally difficult to simultaneously increase both fill factor and open circuit voltage. On the other hand, if a structure between an electrode and a substrate, which is necessary to obtain a high-efficiency crystalline silicon solar cell with high open circuit voltage (Voc) and fill factor (FF), is clarified, a guideline for manufacturing a high-efficiency crystalline silicon solar cell can be obtained.

Accordingly, it is an object of the present invention to provide a high-efficiency crystalline silicon solar cell having high open circuit voltage (Voc) and fill factor (FF). In particular, it is an object of the present invention to provide a crystalline silicon solar cell having a predetermined structure between an electrode and a substrate in order to obtain a high-efficiency crystalline silicon solar cell having high open circuit voltage (Voc) and fill factor (FF).

In order to solve the above problem, the present invention has the following configurations.

(Configuration 1)

Configuration 1 is a solar cell comprising:

a substrate comprising crystalline silicon, the substrate comprising an impurity diffusion layer on at least one surface;
a passivation film disposed on at least a part of the impurity diffusion layer of the substrate; and
an electrode comprising silver (Ag), the electrode disposed on at least a part of the passivation film,
wherein
the solar cell further comprises at least one AgSi region disposed in at least a portion between the electrode and the substrate;
the AgSi region comprises at least one AgSi region having a depth of 100 nm or more;
a remaining ratio of the passivation film, which is a ratio of a length of the passivation film remaining in a scanning electron microscope photograph of a 5.7 $\mu$m $\times$ 3.9 $\mu$m cross-section comprising the AgSi region of the solar cell, is 10 to 90%.

(Configuration 2)

Configuration 2 is the solar cell of Configuration 1, wherein a ratio Db / Da between a film thickness Da of the passivation film immediately after deposition and a film thickness Db of the passivation film in a scanning electron microscope photograph of a 5.7 $\mu$m $\times$ 3.9 $\mu$m cross-section comprising the AgSi region of the solar cell completed by forming the electrode on the surface of the solar cell, is 15% to 85%.

(Configuration 3)

Configuration 3 is the solar cell of Configuration 1 or 2, wherein the electrode further comprises 0.1 to 5.0 parts by weight of glass frit relative to 100 parts by weight of the silver (Ag) contained in the electrode.

(Configuration 4)

Configuration 4 is the solar cell of Configuration 3, wherein the glass transition temperature of the glass frit is 250 to 600 degree C.

(Configuration 5)

Configuration 5 is the solar cell of Configuration 3 or 4, wherein the glass frit comprises at least one selected from $SiO_2$, $B_2O_3$, $V_2O_5$, $Bi_2O_3$, $TeO_2$, $Li_2O$ and ZnO.

(Configuration 6)

Configuration 6 is the solar cell of any of Configurations 3 to 5, wherein the glass frit does not comprise substantially PbO.

(Configuration 7)

Configuration 7 is the solar cell of any of Claim 1 to 6, wherein the electrode does not comprise substantially lead (Pb).

(Configuration 8)

Configuration 8 is the solar cell of any of Configurations 1 to 7, wherein the electrode does not comprise substantially aluminum particles.

(Configuration 9)

Configuration 9 is the solar cell of any of Configurations 1 to 8, wherein

the substrate is a crystalline silicon substrate of a first conductivity type,
the impurity diffusion layer is an impurity diffusion layer of a second conductivity type,
the electrode is a light incident side surface-electrode disposed on a light incident side surface,
the solar cell further comprising a back side electrode disposed so as to be electrically connected to a surface opposite to the light incident side surface of the crystalline silicon substrate,
the light incident side surface-electrode is a light incident side surface-electrode that is processed to irradiate light from a point light source to the light incident side surface of the solar cell, while applying a voltage between the back side electrode and the light incident side surface-electrode such that an electric current flows between the impurity diffusion layer of the second conductivity type and the semiconductor substrate of the first conductivity type in a direction opposite to the forward bias direction.

According to the present invention, a high-efficiency crystalline silicon solar cell having high open circuit voltage (Voc) and fill factor (FF) can be provided. In particular, according to the present invention, a crystalline silicon solar cell having a predetermined structure between an electrode and a substrate in order to obtain a high-efficiency crystalline silicon solar cell having high open circuit voltage (Voc) and fill factor (FF) can be provided.

BRIEF DESCRIPTION OF THE DRAWINGS

Fig. 1 is an example of a cross-sectional schematic diagram of a crystalline silicon solar cell of the present embodiment.
Fig. 2 is an example of a schematic diagram of a light incident side surface of a crystalline silicon solar cell.
Fig. 3 is an example of a schematic diagram of the back surface of a crystalline silicon solar cell.

Fig. 4 is an example of a cross-sectional schematic diagram of a bifacial crystalline silicon solar cell of the present embodiment.

Fig. 5 is an example of a cross-sectional schematic diagram of a typical crystalline silicon solar cell in the vicinity where a light incident side surface-electrode (a finger electrode) exists, and is a cross-sectional schematic diagram showing a state where an antireflection film (a passivation film) between an electrode and an impurity diffusion layer disappears due to firing through.

Fig. 6 is a cross-sectional SEM (scanning electron microscope) photograph (magnification: 20,000 times) in the vicinity of a passivation film of a light incident side surface of a crystalline silicon solar cell of Example 3, for illustrating a depth d of the AgSi region.

Fig. 7 is a cross-sectional SEM (scanning electron microscope) photograph (magnification: 20,000 times) in the vicinity of a passivation film of a light incident side surface of a crystalline silicon solar cell of Example 3, for illustrating a remaining ratio Lp / (Lp + Le) of the passivation film.

Fig. 8 is a cross-sectional SEM (scanning electron microscope) photograph (magnification: 20,000 times) in the vicinity of a passivation film of a light incident side surface of a crystalline silicon solar cell of Comparative Example 1.

MODE FOR CARRYING OUT THE INVENTION

Embodiments of the present invention will be specifically described below. The following embodiments are embodiments of the present invention, and the present invention is not limited within the scope thereof.

<Solar Cell>

Fig. 1 shows an example of a cross-sectional schematic diagram of a solar cell of the present embodiment. The solar cell of the present embodiment includes a substrate containing a crystalline silicon (a crystalline silicon substrate 1), a passivation film 2, and an electrode (for example, a light incident side surface-electrode 20). The solar cell of the present embodiment also includes at least one AgSi region 30 disposed at least partially between the electrode and the substrate.

<<Substrate>>

The solar cell of the present embodiment includes a substrate. The substrate of the solar cell of the present embodiment is a crystalline silicon substrate 1. Therefore, the solar cell of the present embodiment is a crystalline silicon solar cell.

In the present specification, "crystalline silicon" includes single crystalline silicon and polycrystalline silicon. "Crystalline silicon substrate" refers to a material obtained by forming crystalline silicon into a shape suitable for element formation such as a flat plate for forming a semiconductor device such as an electric element or an electronic element. Any method of manufacturing crystalline silicon may be used. For example, the Czochralski method may be used for single crystalline silicon, and the casting method may be used for polycrystalline silicon. In addition, other methods, such as a polycrystalline silicon produced by a ribbon pulling method or a polycrystalline silicon formed on a substrate of a different material such as glass, may be used as the polycrystalline silicon substrate 1. The term "crystalline silicon solar cell" refers to a solar cell produced using a crystalline silicon substrate 1. In the present specification, a crystalline silicon substrate 1 may be simply referred to as a "substrate".

In a typical solar cell, crystalline silicon, silicon carbide, germanium, gallium arsenide, and the like can be used as a material of a semiconductor substrate of a solar cell. From the viewpoint of safety and cost as a solar cell, the material of a semiconductor substrate is preferably crystalline silicon (single crystalline silicon, polycrystalline silicon and the like).

A crystalline silicon substrate 1 of a solar cell of the present embodiment is an n-type crystalline silicon substrate 1 or a p-type crystalline silicon substrate 1 containing n-type or p-type impurities. The n-type impurities contained in the n-type crystalline silicon substrate 1 include the group 13 elements such as boron (B), aluminum (Al), and gallium (Ga). The p-type impurities contained in the p-type crystalline silicon substrate 1 include the group 15 elements such as phosphorus (P), arsenic (As), and antimony (Sb).

As shown in Fig. 1, the solar cell of the present embodiment contains an impurity diffusion layer 4 on at least one part of the surface of the crystalline silicon substrate 1. In the case of the solar cell of the present embodiment, the impurity diffusion layer 4 formed on the light incident side surface is a p-type or an n-type impurity diffusion layer 4. In the present specification, as shown in Fig. 1, the portion of the substrate where the impurity diffusion layer 4 is not formed is sometimes referred to as a "substrate main body 6".

In the present specification, in the crystalline silicon containing the n-type or the p-type impurity, one conductivity type (the n-type or the p-type) is referred to as a first conductivity type, and the other conductivity type (the p-type or the n-type) which is not the first conductivity type is referred to as a second conductivity type. When a crystalline silicon substrate 1 is the first conductivity type, an impurity diffusion layer 4 is the impurity diffusion layer 4 of the second conductivity type.

Specifically, when a crystalline silicon substrate 1 is the n-type crystalline silicon substrate 1 containing the n-type impurities, an impurity diffusion layer 4 formed on at least one surface of the crystalline silicon substrate 1 is the p-type impurity diffusion layer 4. When a crystalline silicon substrate 1 is the p-type crystalline silicon substrate 1 containing the p-type impurities, an impurity diffusion layer 4 formed on at least one surface of the crystalline silicon substrate 1 is the n-type impurity diffusion layer 4. Thus, by selecting the first and second conductivity types, a p-n junction can be formed near the surface of the crystalline silicon substrate 1 where the impurity diffusion layer 4 is formed.

The crystalline silicon substrate 1 of the first conductivity type of the present embodiment of the solar cell is preferably an n-type crystalline silicon substrate. The impurity diffusion layer 4 of the second conductivity type of the solar cell of the present embodiment is preferably a p-type impurity diffusion layer 4. Generally, the mobility of electrons as carriers in the n-type crystalline silicon substrate 1 is higher than that of holes as carriers in the p-type crystalline silicon substrate 1. Therefore, it is advantageous to use the n-type crystalline silicon substrate 1 to obtain a solar cell with high conversion efficiency.

The sheet resistance of the impurity diffusion layer 4 is preferably 30 to 300 $\Omega/\square$ (square), 40 to 160 $\Omega/\square$ (square), and more preferably 45 to 120 $\Omega/\square$. A depth of the impurity diffusion layer 4 may be 0.3 $\mu m$ to 1.0 $\mu m$. The depth of the impurity diffusion layer 4 refers to a depth from the surface of the impurity diffusion layer 4 to the p-n junction. The depth of the p-n junction may be a depth from the surface of the impurity diffusion layer 4 until an impurity concentration in the impurity diffusion layer 4 becomes equivalent to an impurity concentration of the substrate main body 6.

In the present specification, the impurity diffusion layer 4 of the crystalline silicon solar cell of the present embodiment may be referred to as a "silicon emitter layer 4".

<<Passivation Film 2>>

The solar cell of the present embodiment includes a passivation film 2. The passivation film 2 is disposed on at least a part of the impurity diffusion layer 4 of the substrate.

The passivation film 2 can have a function as an antireflection film. In the present specification, the passivation film 2 formed on the light incident side surface of the crystalline silicon substrate 1 is sometimes referred to as an antireflection film.

The passivation film 2 can be a film consisting of a single layer or multiple layers. When the passivation film 2 is a single layer, it is preferable to be a thin film (a SiN film) made of silicon nitride (SiN), because passivation of the surface of the silicon substrate can be performed effectively. When the passivation film 2 is multiple layers, it can be a laminated film (SiN / SiO$_x$ film) made of a thin film made of silicon nitride and a thin film made of silicon oxide. When the SiN / SiO$_x$ film is the passivation film 2, it is preferable to form the SiOx film so that the SiOx film contacts the silicon substrate 1, and to form the SiN film on the SiOx film, because passivation of the surface of the silicon substrate can be performed more effectively. The SiO$_x$ film can be a native oxide film of the silicon substrate.

Fig. 5 shows an example of a cross-sectional schematic diagram of a typical crystalline silicon solar cell. As shown in Fig. 5, in a typical crystalline silicon solar cell, a passivation film 2 (an antireflection film) is formed on an impurity diffusion layer 4. Furthermore, an electrode pattern of a light incident side surface-electrode 20 (a surface electrode) is printed on the passivation film 2 using a conductive paste by a screen printing method or the like, and the conductive paste is dried and fired at a predetermined temperature to form the light incident side surface-electrode 20. In a typical crystalline silicon solar cell, the conductive paste fires through the passivation film 2 at the predetermined temperature. By this firing through, the light incident side surface-electrode 20 can be formed in contact with the impurity diffusion layer 4. The fire through means that the passivation film 2, which is an insulating film, is etched with glass frit or the like included in the conductive paste to form electrical continuity between the light incident side electrodes 20 and the impurity diffusion layer 4. In the example of the typical crystalline silicon solar cell shown in Fig. 5, during the firing of the electrode pattern, the electrode pattern fires through the passivation film 2, so that the passivation film 2 disappears and the light incident side surface-electrode 20 and the impurity diffusion layer 4 come into contact with each other.

On the other hand, as shown in Fig. 1, in the case of a crystalline silicon solar cell of the present embodiment, the passivation film 2 (an antireflection film) exists in the major portion between the light incident side surface-electrode 20 and the impurity diffusion layer 4. Therefore, in the case of the crystalline silicon solar cell of the present embodiment, the major portion of the passivation film 2 exists in the portion of the crystalline silicon substrate 1 that is in contact with impurity diffusion layer 4, except for the AgSi region 30 described later. The presence of passivation film 2 prevents an increase in density of surface defects that causes carrier recombination. As a result, the crystalline silicon solar cell of the present embodiment can obtain a high open circuit voltage (Voc).

In the case of the crystalline silicon solar cell of the present embodiment, the majority portion of passivation film 2 remains between the electrode and impurity diffusion layer 4 even after firing for forming the electrode. In the present specification, the degree of passivation film 2 remaining between the electrode and the crystalline silicon substrate 1 after firing for forming the electrode is shown as a remaining ratio of passivation film 2. The remaining ratio of the passivation film 2 will be described later.

<<Electrode>>

The solar cell of the present embodiment includes an electrode. The electrode of the solar cell of the present embodiment is disposed on at least a part of passivation film 2. The electrode of the solar cell of the present embodiment contains silver (Ag).

As shown in Fig. 1, a finger electrode 20b is arranged as a light incident side surface-electrode 20 on a light incident side surface of a crystalline silicon solar cell. In the example shown in Fig. 1, holes among electron-hole pairs generated by incident light entering the crystalline silicon solar cell are collected into the finger electrode 20b via the impurity diffusion layer 4 (for example, a p-type impurity diffusion layer 4). Therefore, the contact resistance between the finger electrode 20b and the impurity diffusion layer 4 is required to be low.

The back side electrode 15 is arranged on the opposite side of the light incident side surface of the crystalline silicon solar cell shown in Fig. 1. In the present specification, the light incident side surface-electrode 20 and the back side electrode 15, which are electrodes for extracting the current from the crystalline silicon solar cell to the outside, are sometimes simply referred to as "electrode".

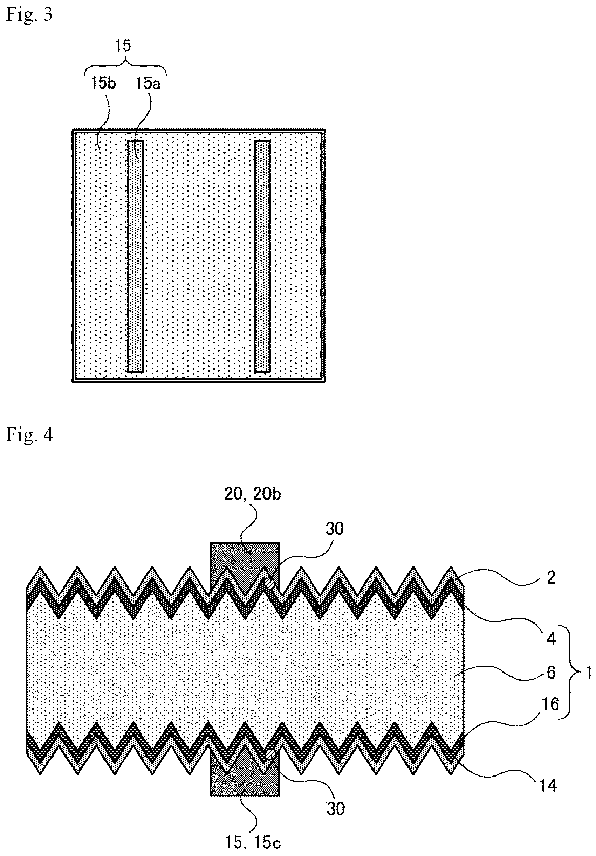

Fig. 4 shows an example of a cross-sectional schematic diagram of a crystalline silicon solar cell for bifacial power generation (a bifacial crystalline silicon solar cell) of the present embodiment. The crystalline silicon solar cell shown in Fig. 4 can generate electricity by incident light from two surfaces (first and second light incident side surfaces).

Generally, an electrodes of crystalline silicon solar cell can be formed by printing a conductive paste using a method such as screen printing method and firing. In the present specification, a conductive paste for forming an electrode of a crystalline silicon solar cell of the present embodiment is sometimes referred to as a predetermined conductive paste. Generally, a conductive paste includes conductive particles and organic vehicles. Also, a conductive paste may include glass frit in addition to conductive particles and organic vehicles. An electrode of solar cell of the present embodiment contains silver (Ag). Therefore, it is necessary that conductive particles contained in a predetermined conductive paste contains silver (Ag). The organic vehicle contained in the conductive paste burns out during firing to form the electrode. Therefore, the electrode after firing contains components contained in the conductive paste other than the organic vehicle. Specifically, the electrode after firing contains a conductive component attributed to conductive particles of conductive paste. If the conductive paste contains a glass frit, the electrode after firing also contains a component attributed to the glass frit of the conductive paste.

In order to obtain low electrical resistance and high reliability, a conductive component contained in a predetermined electrode of a crystalline silicon solar cell of the present embodiment preferably consists of only silver. The conductive component consisting of only silver may contain other metallic elements as unavoidable impurities.

In the present specification, the term "a glass frit" refers to a material mainly composed of a plurality of kinds of oxides, for example, metal oxides, and is generally used in the form of glass-like particles. During firing to form an electrode, the glass frit softens and the particles bond together. In the present specification, a component (oxide) attributed to the glass frit contained in an electrode is also simply referred to as "glass frit".

In the solar cell of the present embodiment, the content of the glass frit contained in the electrode is preferably 0.1 to 5.0 parts by weight, more preferably 0.2 to 4.0 parts by weight, further more preferably 0.3 to 3.0 parts by weight, and particularly preferably 0.4 to 2.7 parts by weight with respect to the content of silver (Ag) contained in the electrode of 100 parts by weight. By controlling the content of the glass frit in an appropriate range, the reactivity of the glass frit against passivation film 2 can be made appropriate during firing to form the electrode.

In the solar cell of the present embodiment, the glass transition temperature of the glass frit contained in the electrode is preferably 250 to 600 degrees C, more preferably 270 to 500 degrees C, and further more preferably 300 to 400 degrees C. By setting the glass transition temperature (Tg) of the glass frit to 250 degrees C or more, a reactivity of the glass frit against passivation film 2 can be suppressed. By controlling the glass transition temperature (Tg) to 600 degrees C or less, a contact resistance between the resulting electrode (for example, a light incident side surface-electrode 20) and the impurity diffusion layer 4 can be reduced.

In the solar cell of the present embodiment, the glass frit contained in the electrode preferably contains at least one selected from $SiO_2$, $B_2O_3$, $V_2O_3$, $Bi_2O_3$, $TeO_2$, BaO, CuO, $Li_2O$, and ZnO. In the solar cell of the present embodiment, the glass frit contained in the electrode preferably contains at least one selected from $SiO_2$, $B_2O_3$, $V_2O_3$, $Bi_2O_3$, $TeO_2$, $Li_2O$, and ZnO. When the glass frit contains at least one of these oxides, the basicity of the glass frit can be adjusted to an appropriate range. By adjusting the basicity of the glass frit to an appropriate range, a reactivity of the glass frit to the passivation film 2 can be made appropriate during firing to form the electrode.

Although not specifically limited, the solar cell of the present embodiment may have substantially no PbO in the glass frit contained in an electrode. The electrode of a solar cell of the present embodiment may also have substantially no lead (Pb). As used herein, a lead-free glass frit means a glass frit that does not contain lead (Pb) substantially. Since the glass frit is manufactured from metal oxides, a lead-free glass frit means a glass frit that does not contain lead (Pb) substantially. When manufacturing a lead-free glass frit, no lead-containing material (PbO) is intentionally used. However, a lead-free glass frit may contain a trace amount of lead that is inevitably mixed as an impurity. Specifically, a lead-free glass frit of the present embodiment may contain 0.1 weight % or less of lead as an impurity compared to 100 weight % of glass frit.

In the manufacture of a typical crystalline silicon solar cell, a glass frit containing lead oxide (PbO) is used as the glass frit in the conductive pastes for electrode formation. In the case of a typical crystalline silicon solar cell, because the conductive paste for electrode formation contain a glass frit containing lead, the contact resistance between a light incident side surface-electrode 20 and an impurity diffusion layer 4 can be reduced. However, lead has adverse effects on the human body. When a product is manufactured using materials containing lead, lead may pollute the environment when the product is disposed of. Therefore, when a product is manufactured, it is desirable to use lead-free materials that do not contain lead. Therefore, it is preferable to use a lead-free glass frit in the manufacturing process of a solar cell. By using a lead-free glass frit, it is possible to manufacture solar cells that have electrodes that practically do not contain lead (Pb). Therefore, environmental pollution caused by lead can be suppressed.

In the present embodiment, in the crystalline silicon solar cell of the present embodiment, it is possible that materials other than the electrodes also do not contain lead. To prevent contamination of the environment by lead, the crystalline silicon solar cell of the present embodiment is preferably a lead-free solar cell.

The electrode of the solar cell of the present embodiment may further contain an aluminum component attributed to aluminum particles. The aluminum particles may be contained as particles separate from the conductive particles (A). If a conductive paste used to form an electrode contains aluminum, the electrode also contains aluminum.

In crystalline silicon substrate 1, aluminum has the property of p-type impurity. When a conductive paste printed on crystalline silicon is fired, aluminum in the conductive paste diffuses into crystalline silicon and becomes p-type impurity. Therefore, when an electrode is formed on a surface of p-type semiconductor layer of a crystalline silicon substrate 1, low contact resistance can be obtained between the electrode and the p-type semiconductor layer when the conductive paste contains aluminum particles. Therefore, when an electrode is formed on the surface of p-type semiconductor layer of a crystalline silicon substrate 1, aluminum particles can be contained in the conductive paste.

On the other hand, if a conductive paste contains aluminum particles, the adhesion of an electrode to a p-type semiconductor layer is lowered, and the electrode tends to peel off from the p-type semiconductor layer of the solar cell. That is, if a conductive paste contains aluminum particles, the reliability of an electrode to a p-type semiconductor layer is greatly impaired.

In order to electrically connect a plurality of solar cell cells, a metal ribbon for interconnection is soldered to the electrode of the solar cell. If a conductive paste for electrode formation contains aluminum particles, soldering strength of the metal ribbon to the electrode is lowered.

From the above, it is preferable that the conductive paste of the present embodiment contains aluminum particles in a predetermined amount or less, or does not contain aluminum particles.

Specifically, the aluminum particles are as follows. The conductive paste of the present embodiment further contains 0.5 parts by weight or less of aluminum particles based on 100 parts by weight of silver particles (A), or does not contain aluminum particles. The upper limit of the content of aluminum particles in the conductive paste of the present embodiment is preferably 0.3 parts by weight or less, more preferably less than 0.3 parts by weight, and further more preferably 0.25 parts by weight or less based on 100 parts by weight of silver particles (A). The conductive paste of the present embodiment may be a conductive paste that does not contain aluminum particles. "(it) does not contain aluminum particles" means that "aluminum particles" are not intentionally added, and it does not exclude the inclusion of aluminum components as unavoidable impurities.

Furthermore, in the present invention, at least one AgSi region is formed in at least a part between an electrode and a substrate, so that when an electrode is formed on a surface of a p-type semiconductor layer of a crystalline silicon substrate 1, low contact resistance can be obtained between the electrode and the p-type semiconductor layer even if the electrode substantially does not contain aluminum.

On the other hand, when a conductive paste for forming an electrode contains aluminum, there is an influence from the viewpoint of reliability.

As shown in Figs. 2 and 3, the electrode of the crystalline silicon solar cell may have a light incident side bus bar electrode 20a and/or a back side TAB electrode 15a. The light incident side bus bar electrode 20a has a function of electrically connecting the finger electrode 20b for collecting the electric current generated by the solar cell and the metal ribbon for the interconnection. Similarly, the back side TAB electrode 15a has a function of electrically connecting the back side full-surface electrode 15b for collecting the electric current generated by the solar cell and the metal ribbon for the interconnection. When the finger electrode 20b comes into contact with the crystalline silicon substrate 1, a density of surface defects of the surface (interface) of the crystalline silicon substrate 1 at the portion where the finger electrode 20b comes into contact is increased, and the solar cell performance decreases. In the crystalline silicon solar cell of the present embodiment, the passivation film 2 (the antireflection film) is not completely fired through when forming the finger electrode 20b. Therefore, the majority portion of the passivation film 2 where the crystal silicon substrate 1 comes into contact can be kept as it is, and the density of surface defect which causes carrier recombination can be prevented from increasing. As a result, a crystalline silicon solar cell with a high open circuit voltage (Voc) can be obtained.

The crystalline silicon solar cell shown in Fig. 1 can have a back side electrode 15 having the structure shown in Fig. 3. The back side electrode 15 is arranged to be electrically connected to the other surface of the semiconductor substrate of the first conductivity type. As shown in Fig. 3, the back side electrode 15 can generally include a back side full-surface electrode 15b and a back side TAB electrode 15a electrically connected to the back side full-surface electrode 15b.

The bus bar electrodes of the crystalline silicon solar cell shown in Fig. 1 include a light incident side bus bar electrode 20a shown in Fig. 2 and a back side TAB electrode 15a shown in Fig. 3. The light incident side bus bar electrodes 20a and the back side TAB electrodes 15a are soldered with a metal ribbon covered with solder for interconnection. The metal ribbons allow the current generated by the solar cell to be taken out of the crystalline silicon solar cell. A bifacial crystalline silicon solar cell shown in Fig. 4 may also have a light incident side bus bar electrode 20a and a back side TAB electrode 15a similar in shape to the light incident side bus bar electrode 20a.

A width of the bus bar electrodes (the light incident side bus bar electrode 20a and the back side TAB electrode 15a) may be similar to that of the metal ribbon for interconnection. In order for the bus bar electrode to have a low electrical resistance, a wider width is preferable. On the other hand, in order to increase an incident area of light on the light incident side surface, a narrower width of the light incident side bus bar electrodes 20a is preferable. Therefore, the width of the bus bar electrodes may be 0.05 to 5 mm, preferably 0.08 to 3 mm, more preferably 0.1 to 2 mm, and further more preferably 0.15 to 1 mm. The number of bus bar electrodes can be determined according to the size of the crystalline silicon solar cell. The number of bus bar electrodes is arbitrary. Specifically, the number of bus bar electrodes can be 3, 4, or more. The optimum number of bus bar electrodes can be determined by simulation of solar cell operation so as to maximize the conversion efficiency of the crystalline silicon solar cell. The number of light incident side bus bar electrodes 20a and the number of the back side TAB electrode 15a is preferably the same because the crystalline silicon solar cells are connected in series with each other by a metal ribbon for interconnection. For the same reason, the width of the light incident side bus bar electrodes 20a and the width of the back side TAB electrode 15a is preferably the same.

In order to increase the incident area of light on the crystalline silicon solar cell, the area occupied by the light incident side surface-electrode 20 is preferably as small as possible. For this reason, the finger electrodes 20b on the light incident side surface are preferably as narrow as possible and as few as possible. On the other hand, from the viewpoint of reducing electric loss (ohmic loss), it is preferable that the width of the finger electrodes 20b is wider and the number of the finger electrodes is larger. Also, from the viewpoint of reducing contact resistance between the finger electrodes 20b and the crystalline silicon substrate 1 (the impurity diffusion layer 4), it is preferable that the width of the finger electrodes 20b is wider. From the above, the number of bus bar electrodes can be determined in accordance with the size of the crystalline silicon solar cell and the width of the bus bar electrodes. The optimum width and number of the finger electrodes 20b (spacing of the finger electrodes 20b) can be determined by simulation of solar cell operation so as to maximize the conversion efficiency of the crystalline silicon solar cell. The width and number of the back side finger electrodes 15c of the back side electrode 15 of the bifacial crystalline silicon solar cell shown in Fig. 4 can be determined in the same manner.

<<AgSi Region 30>>

The solar cell of the present embodiment includes at least one AgSi region 30. The AgSi region 30 is disposed at least partially between the electrode and the substrate. An example of the AgSi region 30 is shown in the SEM photograph of Fig. 6. The AgSi region 30 may be disposed at least partially between the electrode and the substrate. For example, the region indicated by the symbol 30 surrounded by a dotted line in the SEM photograph of Fig. 6 may also be the AgSi region 30.

When the solar cell of the present embodiment is manufactured, the silver (Ag) contained in the electrode diffuses into silicon (Si) of the substrate, thereby forming an alloy region of silver (Ag) and silicon (Si) at least partially between the electrode and the substrate. In the present specification, the alloy region of silver (Ag) and silicon (Si) formed when the solar cell of the present embodiment is manufactured is referred to as a "AgSi region 30." The AgSi region 30 can be identified as the region where both Ag and Si are detected when a cross-section of the solar cell of the present embodiment is measured by an Energy Dispersive X-ray Fluorescence Spectrometer (hereinafter referred to as EDX.).

One AgSi region 30 means an AgSi region 30 separated from the other AgSi regions 30. The SEM photograph in Fig. 6 shows one AgSi region 30. The solar cell of the present embodiment preferably has a plurality of spotty AgSi regions 30 at least partially between the electrode and the substrate. The AgSi region 30 contributes to electrical conduction between the electrode and the impurity diffusion layer 4 as a local conductive portion.

In the crystalline silicon solar cell of the present embodiment, for example, when a cross-section of 1 mm in length, which is a part of the finger electrode, is observed by SEM, approximately 1 to 3 spot(s) of AgSi regions 30 are included. Therefore, it can be said that the portion where the AgSi regions 30 exist is an extremely small portion of the region where the electrode is formed.

The crystalline silicon solar cell of the present embodiment includes at least one AgSi region 30 having a depth d of 100 nm or more.

In the present specification, the depth d of the AgSi region 30 refers to a length (a length d of the line segment connecting B1 and B2 in Fig. 6) of the line segment that is the maximum length among the line segments connecting an arbitrary point (B1 in Fig. 6) at the interface between the electrode and the AgSi region 30 to an arbitrary point (B2 in Fig. 6) at the interface between the substrate and the AgSi region 30, in the SEM photograph of the cross-section of the AgSi region 30 as shown in Fig. 6. Specifically, the depth d of the AgSi region 30 can be obtained by superimposing the AgSi region 30 determined by EDX measurement on the SEM photograph of the cross-section near the passivation film 2 observed by SEM at a magnification of 20,000 times, determining the above-mentioned predetermined line segment, and measuring the length of the predetermined line segment.

The depth d of the AgSi region 30 is preferably 100 to 4000 nm, more preferably 120 to 3000 nm, further more preferably 130 to 2500 nm, and particularly preferably 150 to 2000 nm. By having the depth d of the AgSi region 30 in this range, contact resistance is reduced, and high-efficiency crystalline silicon solar cells with fill factor (FF) can be obtained.

In the solar cell of the present embodiment, the AgSi region 30 described above is preferably an AgSi region 30 formed by performing a laser treatment process. The laser treatment process refers to a process for the light incident side surface-electrode 20, which is irradiating the light incident side surface of a solar cell with light from a point light source while applying a voltage between the back side electrode 15b and the light incident side surface-electrode 20 so that a current flows between the impurity diffusion layer 4 of the second conductivity type and the crystalline silicon substrate 1 of the first conductivity type in the opposite direction from the forward direction. In this case, the solar cell further includes a back side electrode 15b arranged so as to be electrically connected to the surface opposite to the light incident side surface of the crystalline silicon substrate 1. An appropriate AgSi region 30 can be formed by the laser treatment process.

Details of the laser treatment process will be described later.

Fig. 4 shows an example of a cross-sectional schematic diagram of a bifacial crystalline silicon solar cell. The bifacial crystalline silicon solar cell shown in Fig. 4 has an impurity diffusion layer 4, a passivation film 2 (an antireflection film) and a back side passivation film 14. The predetermined structure of the electrode including the AgSi region 30 can be suitably applied as a structure of the back side electrode 15 (the back side finger electrode 15c) of the bifacial crystalline silicon solar cell as shown in Fig. 4. Therefore, in the bifacial crystalline silicon solar cell, when a light incident side surface-electrode 20 (in particular, a finger electrode 20b) and a back side electrode 15 (a back side finger electrode 15c) of the light incident side surfaces are formed, the predetermined AgSi region 30 can be formed both near the light incident side surface and near the back surface.

<<Remaining ratio of passivation film 2>>

In the present specification, the degree to which the passivation film 2 exists between the electrode and the impurity diffusion layer 4 of the crystalline silicon substrate 1 after the firing to form the electrode of the solar cell of the present embodiment can be shown as a remaining ratio of the passivation film 2. In the part where the AgSi region 30 is formed, the passivation film 2 disappears. Since the AgSi region 30 is not formed in the part where the passivation film 2 exists, the remaining ratio of the passivation film 2 is considered to be the ratio of the area where the AgSi region 30 is not formed in the vicinity of the AgSi region 30.

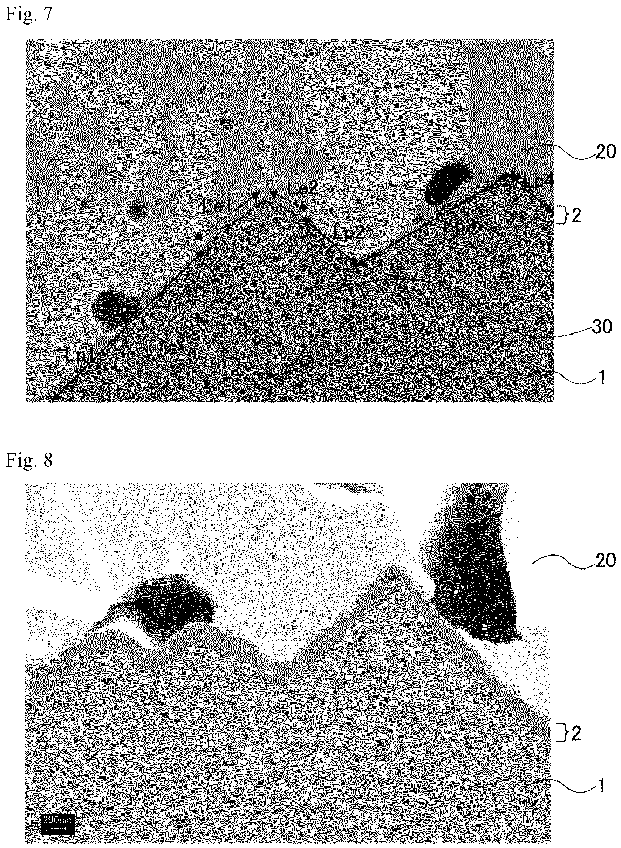

The measurement method of the remaining ratio of the passivation film 2 will be described using an example of the SEM photograph of a cross-section of a solar cell shown in Fig. 7. First, in order to obtain the remaining ratio of the passivation film 2, the cross-section including the passivation film 2 and the AgSi region 30 is observed by SEM at a magnification of 20,000 times to obtain a SEM photograph. In this SEM photograph, the length in the transverse direction (in the horizontal direction from the substrate surface) is 5.7 μm, and the length in the longitudinal direction (in the vertical direction from the substrate surface) is 3.9 μm. Next, a total length Lp of the cross-section of the passivation film 2 in this SEM photograph is measured. In the example shown in Fig. 7, the total length Lp of the cross-section of the passivation film 2 in the SEM photograph is the total length of Lp1, Lp2, Lp3 and Lp4. Next, in this SEM photograph, the total length Le of the cross-section of the interface between the AgSi region 30 and the electrode in the portion where the AgSi region 30 is generated is measured. The length Le corresponds to the length of the passivation film 2 lost in the solar cell manufacturing process. In the example shown in Fig. 7, the total length Le of the cross-section of the interface between the AgSi region 30 and the electrode in the portion where the AgSi region 30 is generated is the total length of Le1 and Le2. The remaining ratio of the passivation film 2 can be obtained as Lp / (Lp + Le). The portion of the passivation film 2 lost in the solar cell manufacturing process can be identified by EDX measurement. The length of Le1, etc. can be measured by approximating that the passivation film 2, etc. is a straight line.

In the crystalline silicon solar cell of the present embodiment, the remaining ratio of passivation film 2 is 10 to 90%, preferably 30% to less than 90%, more preferably 50% to less than 90%, and further more preferably 70% to 89%. When the remaining ratio of passivation film 2 is in an appropriate range, highly efficient crystalline silicon solar cell having high open circuit voltage (Voc) and fill factor (FF) can be obtained.

<<Film Thickness Ratio of Passivation Film 2 before and after Firing>>

In the present specification, the film thickness ratio of passivation film 2 before and after firing is the ratio (Db / Da) of a film thickness Da before firing for electrode formation of passivation film 2 and a film thickness Db after firing for electrode formation (after completion of a solar cell). In the present specification, the film thickness ratio before and after firing is sometimes simply referred to as "film thickness ratio (Db / Da)."

In the solar cell of the present embodiment, the film thickness ratio (Db / Da) is preferably 15% to 85%, more preferably 20 to 70%, and further more preferably 30 to 60%. By having the film thickness ratio (Db / Da) of passivation film 2 within a predetermined range, it is possible to prevent an increase in density of surface defect which causes carrier recombination when the solar cell of the present embodiment generates power.

In the present specification, the film thickness Da before firing of the passivation film 2 refers to the film thickness of the passivation film 2 when the passivation film 2 is formed on a predetermined substrate. The film thickness Da immediately after the film formation can be measured by SEM observation of the cross-section near the passivation film 2 before the electrode is formed.

In the present specification, the film thickness Db after the completion of the solar cell is the film thickness of the passivation film 2 in the scanning electron microscope photograph of a 5.7 $\mu$m × 3.9 $\mu$m cross-section including the AgSi region 30 of the completed solar cell after the electrode is formed on the surface of the solar cell by firing.

In the present specification, the film thickness Db of the passivation film 2 in the scanning electron microscope photograph of a 5.7 $\mu$m × 3.9 $\mu$m cross-section including the AgSi region 30 of the completed solar cell after forming the electrode on the surface of the completed solar cell is the film thickness of the passivation film 2 near the AgSi region 30 of the completed solar cell after the electrode and the AgSi region 30 are formed by forming an electrode pattern on the passivation film 2 formed on a predetermined substrate using a predetermined conductive paste and performing a predetermined treatment such as predetermined firing. The film thickness Db is sometimes referred to as "film thickness Db after completion of solar cell." The film thickness Db after completion of solar cell can be measured by SEM observation of an image range of 5.7 $\mu$m × 3.9 $\mu$m of the cross-section including the passivation film 2 and the AgSi region 30 of the completed solar cell after the electrode and the AgSi region 30 are formed. That is, the film thickness Db after completion of solar cell is the film thickness Db of the passivation film 2 in the scanning electron microscope photograph of a 5.7 $\mu$m × 3.9 $\mu$m cross-section including the AgSi region 30 of the completed solar cell. Specifically, the film thickness Db of the passivation film 2 after completion of solar cell can be obtained by SEM observation of the cross-section including the passivation film 2 and the AgSi region 30 at a magnification of 20,000 times to obtain an SEM photograph (SEM image range: 5.7 $\mu$m × 3.9 $\mu$m), dividing the SEM photograph vertically into 6 equal portions, measuring the film thickness of the passivation film 2 at 5 boundaries of the 6 equal portions of the image (at 5 locations), and obtaining the average value of the film thickness at 5 locations.

<Method for Producing Solar Cells>

Next, a method for producing a crystalline silicon solar cell of the present embodiment will be described.

The method for producing a solar cell of the present embodiment includes a step of forming an electrode (a light incident side surface-electrode 20) by printing a predetermined conductive paste onto a surface of a passivation film 2 (an antireflection film) on a semiconductor layer of a second conductivity type (an impurity diffusion layer 4), drying, and firing. The predetermined conductive paste will be described later.

The method for producing solar cells of the present embodiment includes a step of preparing a crystalline silicon substrate 1 of a first conductivity type (p-type or n-type). As the semiconductor substrate of the first conductivity type, an n-type crystalline silicon substrate 1 or a p-type crystalline silicon substrate 1 can be used. In the solar cell of the present embodiment, it is preferable to use the n-type crystalline silicon substrate 1 because it is possible to obtain a solar cell with higher efficiency.

In order to obtain high conversion efficiency, it is preferable that a surface of light incident side of the crystalline silicon substrate 1 has a pyramid-like texture structure.

Next, the method of producing the solar cell of the present embodiment includes a step of forming a second conductivity type impurity diffusion layer 4 on one surface of the semiconductor substrate of the first conductivity type.

When an n-type crystalline silicon substrate 1 is used as the crystalline silicon substrate 1, a p-type impurity diffusion layer 4 in which B (boron), which is a p-type impurity, is diffused, for example, can be formed as the impurity diffusion layer 4. It is also possible to produce a crystalline silicon solar cell using a p-type crystalline silicon substrate 1. In this case, an n-type impurity diffusion layer 4 in which P (phosphorus), which is an n-type impurity, is diffused, is formed as the impurity diffusion layer 4.

When the impurity diffusion layer 4 is formed, the sheet resistance of the impurity diffusion layer 4 can be 30 to 300 $\Omega/\square$ (square), preferably 40 to 150 $\Omega/\square$, more preferably 45 to 120 $\Omega/\square$. In the present embodiment of the method for producing the crystalline silicon solar cell, the depth of the impurity diffusion layer 4 can be 0.3 $\mu$m to 1.0 $\mu$m. The sheet

resistance and depth of the impurity diffusion layer 4 can be controlled by adjusting conditions such as the concentration of dopant applied to the crystalline silicon substrate 1 and the temperature and/or time for diffusion of impurity elements.

The present embodiment of the method for producing the crystalline silicon solar cell includes a step of forming a back side electrode 15 so as to be electrically connected to the other surface of the semiconductor substrate 1 of a first conductivity type (the n-type crystalline silicon substrate 1). The back side electrode 15 can be either before or after the light incident side surface-electrode 20 is formed. The firing to form the back side electrode 15 can be performed simultaneously with or separately from the firing to form the light incident side surface-electrode 20.

Specifically, in the present embodiment of the method for producing the crystalline silicon solar cell, the back side electrode 15 is formed by printing conductive paste on the other surface (the back surface) of the crystalline silicon substrate 1 and firing.

When a bifacial crystalline silicon solar cell shown in Fig. 4 is produced, the second impurity diffusion layer 16 can be formed. On the other hand, the back side electrode 15 can be formed using the predetermined conductive paste (a conductive composition), and the above-mentioned AgSi region 30 can be formed between the back side electrode 15 and the crystalline silicon substrate 1. Therefore, in the case of the bifacial crystalline silicon solar cell, it is preferable to form the back side electrode 15 using the predetermined conductive paste. In this case, the back side electrode 15 is a fired body of the predetermined conductive paste.

Next, the present embodiment of the method for producing the solar cell includes forming a passivation film 2 so as to contact the surface of the semiconductor layer of a second conductivity type (an impurity diffusion layer 4). The passivation film 2 can function as an antireflection film.

Specifically, in the present embodiment of the method for producing the crystalline silicon solar cell, the antireflection film which also functions as the passivation film 2 is formed on the surface of the impurity diffusion layer 4 formed in the above-described process. As the passivation film 2 (antireflection film), a silicon nitride film (SiN film) can be formed. When the silicon nitride film is used as the passivation film 2, the layer of the silicon nitride film also functions as the passivation film 2 of the light incident side surface. Therefore, when the silicon nitride film is used as the passivation film 2, a crystalline silicon solar cell with high performance can be obtained. In addition, since the passivation film 2 is a silicon nitride film, it can exhibit an antireflection function against incident light. The silicon nitride film can be formed by the PECVD (Plasma Enhanced Chemical Vapor Deposition) method or the like.

The present embodiment of the method for producing the solar cell includes a step of forming a light incident side surface-electrode 20 on at least a part of the surface of the passivation film 2 (the antireflection film). In the present embodiment of the producing method, the predetermined conductive paste described later is used to form the light incident side surface-electrode 20. Therefore, the light incident side surface-electrode 20 is a fired body of the predetermined conductive paste.

In the present embodiment of the method for producing the crystalline silicon solar cell, the predetermined conductive paste is printed on the surface of the passivation film 2 (the antireflection film) and fired to form the light incident side surface-electrode 20. When firing to form the light incident side surface-electrode 20, firing to form the back side electrode 15 can be performed simultaneously.

Specifically, first, a pattern of the light incident side surface-electrode 20, which is printed using the predetermined conductive paste, is dried at a temperature of about 100 to 150 degree C for several minutes (for example, 0.5 to 5 minutes). At this time, the light incident side bus bar electrode 20a and the light incident side finger electrode 20b of the light incident side surface-electrode 20 can be formed using the predetermined conductive paste.

After printing and drying the pattern of the light incident side surface-electrode 20, a conductive paste for forming the back side electrode 15 is printed and dried. The predetermined conductive paste can preferably be used to form the electrode (the light incident side surface-electrode 20 and possibly the back side electrode 15) of the solar cell such as a crystalline silicon solar cell.

Thereafter, the printed conductive paste is dried and fired under predetermined firing conditions in air using a firing furnace such as a tubular furnace. As the firing conditions, the firing atmosphere is in air, and the firing temperature is 500 to 1000 degree C, more preferably 600 to 1000 degree C, further more preferably 500 to 900 degree C, and particularly preferably 700 to 900 degree C. The firing is preferably performed in a short time, and a temperature profile (a temperature-time curve) during firing is preferably peak-like. For example, with the aforementioned temperature as the peak temperature, the in-out time of the firing furnace is preferably 10 to 100 seconds, more preferably 20 to 80 seconds, and further more preferably 40 to 60 seconds.

During firing, the conductive paste for forming the light incident side surface-electrode 20 and the back side electrode 15 is preferably fired simultaneously to form both electrodes simultaneously. By printing the predetermined conductive paste on the light incident side surface and the back side surface and firing them simultaneously, only one firing for forming the electrodes can be performed. Therefore, the crystalline silicon solar cell can be manufactured at a lower cost.

The present embodiment of the method for producing the solar cell includes the step of forming the AgSi region 30 described above. In the present embodiment of the method for producing the solar cell, for example, a laser treatment process can be performed to form the AgSi region 30 described above.

The laser treatment process refers to a process of irradiating the light incident side surface of the solar cell with light from a point light source while applying a voltage to the back side electrode 15 and the light incident side surface-electrode 20 so that an electric current flows in a direction opposite to the forward direction of the p-n junction between the semiconductor layer of the second conductivity type and the semiconductor substrate of the first conductivity type. The light from the point light source generates carriers (electron-hole pairs) in the semiconductor substrate, and the carriers can move, i.e., an electric current can flow, by applying a voltage. The voltage is applied so that the electric current flows in a direction opposite to the forward direction of the p-n junction. Therefore, when the semiconductor substrate is an n-type semiconductor substrate and the semiconductor layer is a p-type semiconductor layer, a voltage is applied to the back side electrode 15 and the light incident side surface-electrode 20 so that the electric current flows from the n-type semiconductor substrate to the p-type semiconductor layer. Also, when the semiconductor substrate is a p-type semiconductor substrate and the semiconductor layer is an n-type semiconductor layer, a voltage is applied to the back side electrode 15 and the light incident side surface-electrode 20 so that the electric current flows from the n-type semiconductor layer to the p-type semiconductor substrate.

In the following description, a solar cell in which the first conductivity type semiconductor substrate is an n-type crystalline silicon substrate 1 and the second conductivity type semiconductor layer is a p-type impurity diffusion layer 4 (sometimes it is simply called "impurity diffusion layer 4".) is used as an example.

As shown in Fig. 1, when the laser treatment process is used, there is a passivation film 2 (an antireflection film) in the majority portion between the light incident side surface-electrode 20 and the impurity diffusion layer 4. In the laser treatment process, the predetermined voltage described above is applied so that the current flows in the opposite direction from the forward direction at the p-n junction, and light (e.g., laser light) from a point light source is irradiated, so that the current flows in a small area between the light incident side surface-electrode 20 and the impurity diffusion layer 4, and it is locally heated. As a result, as shown in Figs. 6 and 7, a region of silver and silicon alloy, which is a local conductive portion, is formed between the light incident side surface-electrode 20 and the impurity diffusion layer 4. In the present specification, the alloy region of silver (Ag) and silicon (Si) formed by laser treatment process or the like is referred to as "AgSi region 30." The AgSi region 30 can be identified as a region where both Ag and Si are detected by measurement with an Energy Dispersive X-ray Fluorescence Spectrometer (hereinafter referred to as EDX.). The passivation film 2 does not exist in the region where the AgSi region 30 is formed. That is, in the region where the AgSi region 30 is formed, the impurity diffusion layer 4 (the silicon emitter layer of the second conductivity type) is electrically conductive to the light incident side surface-electrode 20 via the AgSi region 30.

Since the locally formed AgSi region 30 is an electrically conductive portion, good electrical conductivity between the light incident side surface-electrode 20 and the impurity diffusion layer 4 is possible.

Generally, the laser treatment process can improve the fill factor (FF) without lowering the open circuit voltage (Voc), which is a characteristic of solar cell characteristics. By forming the predetermined AgSi region 30, higher open circuit voltage (Voc) and higher fill factor (FF) can be obtained.

The crystalline silicon solar cell of the present embodiment can be produced as described above.

A solar cell module can be manufactured by electrically connecting the crystalline silicon solar cells of the present embodiment obtained as described above with a metal ribbon for interconnection and laminating it with a glass plate, a sealant, a protective sheet, etc. A metal ribbon (for example, a ribbon made of copper) covered with solder can be used as the metal ribbon for the interconnection. As the solder, solder available in the market such as lead solder or lead-free solder containing tin as a main component can be used. In order to obtain a lead-free solar cell, lead-free solder is preferably used as the solder.

<Conductive Paste>

The predetermined conductive paste which can be used to form the electrode of the crystalline silicon solar cell of the present embodiment will be described below. This predetermined conductive paste is a conductive paste suitable for forming the above-mentioned AgSi region 30. Hereinafter, a predetermined conductive paste may be referred to as a conductive paste of the present embodiment.

Conductive paste of the present embodiment is less reactive to the passivation film 2 (the antireflection film) than conventional conductive paste, and has an appropriate reactivity with the passivation film 2 (the antireflection film) for laser treatment process. Therefore, the conductive paste of the present embodiment can be preferably used to form the light incident side surface-electrode 20 of the crystalline silicon solar cell using the laser treatment process.

The inventors of the present invention found that when the laser treatment process was applied to a solar cell which formed light incident side surface-electrode 20 using a conventional conductive paste, the passivation film 2 (the antireflection film) and the impurity diffusion layer (and the substrate) are adversely affected, and the conversion efficiency of the solar cell is lowered. The inventors of the present invention have also found that this is caused by the fact that the fire-through properties of the conventional conductive paste to the passivation film 2 (the antireflection film) are too strong.

The conductive paste which can be used to form a light incident side surface-electrode 20 using the laser treatment process must have different properties from the conventional conductive paste (a conductive paste that can fire through the passivation film 2).

Furthermore, the inventors of the present invention found that the reactivity of a glass frit to the passivation film 2 (the antireflection film) can be made appropriate by controlling the basicity and content of a lead-free glass frit in an appropriate range. Since a lead-free glass frit is used as the glass frit, lead contamination due to the discharge of lead into the environment can be prevented, and even when a lead-free glass frit is used, contact resistance can be reduced to the same degree as that of a lead-containing glass frit. Having obtained the above knowledge, the inventors of the present invention have found the conductive paste which can be preferably used in the production of the crystalline silicon using laser treatment process.

By using the conductive paste of the present embodiment to form the electrode of the crystalline silicon solar cell and the performing laser treatment process to form the predetermined AgSi region 30, a low contact resistance can be obtained between the electrode and the impurity diffusion layer 4 of the solar cell without impairing the function of the passivation film 2. Therefore, by using the conductive paste of the present embodiment to perform the laser treatment process to form the predetermined AgSi region 30, a crystalline silicon solar cell with high conversion efficiency can be obtained. The conductive paste of the present embodiment can be preferably used to form the predetermined AgSi region 30 by the laser treatment process in the production of the crystalline silicon solar cell.

The components contained in the conductive paste of the present embodiment will be specifically described.

<<Conductive Particles (A)>>

The conductive paste of the present embodiment includes conductive particles (A).

In the conductive paste of the present embodiment, metal particles or alloy particles can be used as the conductive particles. Examples of metals contained in the metal particles or alloy particles include silver, gold, copper, nickel, zinc and tin. Silver particles (Ag particles) can be used as the metal particles. The conductive paste of the present embodiment can include other metals other than silver, such as gold, copper, nickel, zinc and tin. From the viewpoint of obtaining low electric resistance and high reliability, the conductive particles are preferably silver particles consisting of silver. The silver particles consisting of silver can contain other metal elements as unavoidably contained impurities. A large number of silver particles (Ag particles) may be referred to as silver powder (Ag powder). The same applies to other particles.

The particle shape and particle size (also referred to as particle diameter or particle diameter) of conductive particles are not particularly limited. The particle shape may be, for example, spherical or scaly shape. The particle size of the conductive particles may be defined by the particle size (D50) of the integrated value of 50% of all particles. In the present specification, D50 is also referred to as the average particle size. The average particle size (D50) may be determined from the result of measurement of particle size distribution performed by the micro-tracking method (laser diffraction scattering method).

The average particle size (D50) of the conductive particles is preferably 0.5 to 2.5 $\mu$m, more preferably 0.8 to 2.2 $\mu$m. Since the average particle size (D50) of the conductive particles is within the predetermined range, the reactivity of the conductive paste to the passivation film 2 can be suppressed during firing of the conductive paste. When the average particle size (D50) is larger than the above range, problems such as clogging may occur during screen printing.

The size of the silver particles can be expressed as BET specific surface area (also referred to simply as "specific surface area"). The BET specific surface area of the silver particles is preferably 0.1 to 1.5 $m^2$/g, more preferably 0.2 to 1.2 $m^2$/g. The BET specific surface area can be measured using, for example, a fully automatic specific surface area measuring device, Macsoeb (manufactured by MOUNTEC).

<<Organic Vehicle (B)>>

The conductive paste of the present embodiment includes an organic vehicle (B).

The organic vehicle may include an organic binder and a solvent. The organic binder and the solvent fulfill a role of adjusting a viscosity of the conductive paste, and any of them is not particularly limited. The organic binder may be dissolved in the solvent.

In the conductive paste of the present embodiment, the organic vehicle (B) preferably contains at least one selected from ethyl cellulose, a rosin ester, an acryl and an organic solvent. When the organic vehicle (B) contains at least one selected from an ethyl cellulose, a rosin ester, an acryl and an organic solvent, screen printing of the conductive paste can be suitably performed and the shape of the pattern to be printed can be appropriately shaped.

The organic binder can be selected from cellulosic resins (e.g., ethyl cellulose, nitrocellulose, etc.) and (meth) acrylic resins (for example, polymethyl acrylate or polymethyl methacrylate, etc.). The organic vehicle contained in the conductive paste of the present embodiment preferably contains at least one selected from an ethyl cellulose, a rosin ester, a butyral, an acryl and an organic solvent. The amount of the organic binder to be added is usually 0.1 to 30 parts by weight and preferably 0.2 to 5 parts by weight based on 100 parts by weight of silver particles.

As the organic solvent, one type or two or more types selected from alcohols (for example, terpineol, $\alpha$-terpineol or $\beta$-terpineol, and the like) and esters (for example, hydroxyl group-containing esters, 2,2,4-trimethyl-1,3-pentanediol monoisobutyrate, diethylene glycol monobutyl ether acetate (butyl carbitol acetate), and the like) can be used. The amount of the solvent to be added is usually 0.5 to 30 parts by weight and preferably 2 to 25 parts by weight based on 100 parts by weight of silver particles. Specific example of the organic solvent include diethylene glycol monobutyl ether acetate (butyl carbitol acetate).

<<Glass Frit (C)>>

The conductive paste of the present embodiment includes glass frit (C).

In the conductive paste of the present embodiment, a product $B_{GF} \cdot G$ of a basicity $B_{GF}$ of the glass frit (C) and a content G of the glass frit (C) is in a range of 0.25 to 1.45, preferably in the range of 0.3 to 1.4, and more preferably in the range of 0.4 to 1.2, and the content G of the glass frit (C) is in an unit of part by weight in the conductive paste when a content of the conductive particles (A) in the conductive paste is 100 parts by weight. By setting the product $B_{GF} \cdot G$ of the basicity $B_{GF}$ and the content G of the glass frit to an appropriate range, the reactivity of the glass frit to the passivation film 2 (the antireflection film) can be made appropriate. Therefore, the conductive paste of the present embodiment can be preferably used in the production of crystalline silicon using the laser treatment process.

The basicity of the glass frit can be calculated by the method described in Patent document 3 (JP 2009-231826 A). That is, the "basicity" can be specified as the basicity of the glass powder using the formula shown in "K. Morinaga, H. Yoshida and H. Takebe: J. AmCerm. Soc., 77, 3113 (1994)". In particular, it is as follows.

The binding force between $M_i$ and O in oxide $M_iO$ is given by the following equation as the attractive force $A_i$ between cation and oxygen ion.

$$A_i = Z_i \cdot Z_{02-} / (r_i + r_{02-})^2 = Z_i \cdot 2 / (r_i + 1.40)^2$$

$Z_i$ : valence of cation, oxygen ion is 2
$r_i$ : ionic radius of cation (angstrom)

The ionic radius $r_i$ of oxygen ion is 1.40 nm. Let the reciprocal $B_i$ ($= 1 / A_i$) of $A_i$ in the above equation be the oxygen donating ability of the single component oxide $M_iO$.

$$B_i \equiv 1 / A_i$$

When $B_i$ is normalized as $B_{CaO} = 1$ and $B_{SiO2} = 0$, the $B_i$- index of each single component oxide is given. By expanding the $B_i$- index of each component to a multicomponent system by the cation fraction, the basicity ($= B_{GF}$) of a melt of a glass oxide (glass frit) of an arbitrary composition can be calculated.

$$B_{GF} = \Sigma \, n_i \cdot B_i$$

$n_i$ : cation fraction

The basicity ($B_{GF}$) thus defined represents the oxygen donating ability as described above, and the larger the value, the easier the oxygen donating ability and the easier the exchange of oxygen with other metal oxides. In other words, the "basicity" can be said to represent the degree of dissolution in the glass melt.

The content G of the glass frit (C) is a dimensionless number because it is a ratio to the content of the conductive particles (A). Also, as described above, since $B_i$ is normalized to $B_{CaO} = 1$ and $B_{SiO2} = 0$, the basicity $B_{GF}$ ($= \Sigma \, n_i \cdot B_i$) of the glass frit (C) is a dimensionless number. Therefore, the product $B_{GF} \cdot G$ of the basicity $B_{GF}$ and the content G of the glass (C) frit is also a dimensionless number.

The basicity ($B_{GF}$) of the glass frit of the present embodiment is preferably 0.10 to 1.5, more preferably 0.15 to 1.3, and further more preferably 0.20 to 1.1. When the basicity ($B_{GF}$) is in such a range, the reactivity of the glass frit to the passivation film can be made appropriate by adjusting the amount of the glass frit in the conductive paste.

The content G of glass frit in the conductive paste of the present embodiment is preferably 0.1 to 5.0 parts by weight, more preferably 0.2 to 4.0 parts by weight, further more preferably 0.3 to 3.0 parts by weight, and particularly preferably 0.4 to 2.7 parts by weight, compared to 100 parts by weight of conductive particles. By properly adjusting the glass frit content G in the conductive paste together with the basicity ($B_{GF}$), the reactivity to the passivation film 2 by the glass frit can be made appropriate. More specifically, in order to make the conductive paste suitable for electrode formation by the laser treatment process, the reactivity to the passivation film 2 can be suppressed and Voc can be improved by reducing the glass frit content and setting the basicity of the glass frit to the appropriate range.

In the conductive paste of the present embodiment, the glass transition temperature (Tg) of the glass frit (C) is preferably 250 to 600 degree C, more preferably 270 to 500 degree C, and further more preferably 300 to 400 degree C. By setting the glass transition temperature (Tg) of the glass frit (C) to 250 degree C or more, the reactivity to the passivation film 2 can be suppressed. In addition, by setting the glass transition temperature (Tg) to 600 degree C or less, the contact resistance between the obtained electrode (for example, the light incident side surface-electrode 20) and the impurity diffusion layer 4 can be reduced.

The glass transition temperature (Tg) can be measured as follows. That is, using a thermogravimetric apparatus (TG-DTA2000SA manufactured by McScience Inc., Ltd.), a glass powder to be a sample and a reference material are set in a thermogravimetric apparatus and the temperature is raised from room temperature to 900 degree C at a heating rate of 10 degree C / minute as the measurement condition, and a curve (DTA curve) is obtained in which the temperature difference between the glass powder to be a sample and the reference material is plotted against the temperature. The first inflection point of the DTA curve obtained in this way can be set as the glass transition temperature (Tg).

The shape of the glass frit particles is not particularly limited, and for example, spherical or amorphous particles can be used. The particle size is also not particularly limited. From the viewpoint of workability and the like, the average particle size (D50) of the particles is preferably in the range of 0.1 to 10 $\mu$m, and more preferably in the range of 0.5 to 5 $\mu$m.

As the glass frit included in the conductive paste of the present embodiment, glass frits of different compositions (the first glass frit and the second glass frit) can be used independently.

First, the first glass frit will be described.

The first glass frit included in the conductive paste of the present embodiment preferably contains one or more selected from $SiO_2$, $B_2O_3$, $V_2O_5$, $Bi_2O_3$, $TeO_2$, BaO, CuO, $Li_2O$ and ZnO. The first glass frit contained in the conductive paste of the present embodiment more preferably contains one or more selected from $SiO_2$, $B_2O_3$, $V_2O_5$, $Bi_2O_3$, $TeO_2$, $Li_2O$ and ZnO. When the first glass frit contains at least one of these oxides, the basicity of the first glass frit can be adjusted to an appropriate range.

The first glass frit preferably contains $Bi_2O_3$. The content of $Bi_2O_3$ in the first glass frit (100 mol%) is preferably 10 to 80 mol%, more preferably 15 to 75 mol%, and further more preferably 20 to 70 mol%. When the first glass frit contains $Bi_2O_3$, the reactivity to the passivation film 2 can be adjusted to an appropriate range and the contact resistance can be reduced.

In the conductive paste of the present embodiment, a product $C_{Bi2O3} \cdot G$ of a content of $Bi_2O_3$ in mol% ($C_{Bi2O3}$) in the first glass frit and a content G of the first glass frit, is preferably in the range of 10 to 200, more preferably in the range of 13 to 170, and further more preferably in the range of 15 to 150. When the product $C_{Bi2O3} \cdot G$ with the content G of the glass frit is in the above range, the reactivity to the passivation film 2 can be adjusted to an appropriate range and the contact resistance can be reduced.

The first glass frit may contain $SiO_2$ to the extent that it does not adversely affect the conductive paste of the present embodiment. When the first glass frit contains $SiO_2$, the content of $SiO_2$ in the first glass frit (100 mol%) is preferably 10 to 60 mol% and more preferably 15 to 40 mol%. The reactivity of the first glass frit to passivation film 2 can be controlled by containing an appropriate amount of $SiO_2$.

The first glass frit may contain $B_2O_3$ to the extent that it does not adversely affect the conductive paste of the present embodiment. When the first glass frit contains $B_2O_3$, the content of $B_2O_3$ in the first glass frit (100 mol%) is preferably 3 to 60 mol% and more preferably 4 to 50 mol%. The reactivity of the first glass frit to passivation film 2 can be controlled by containing an appropriate amount of $B_2O_3$.

The first glass frit may contain $V_2O_5$ to the extent that it does not adversely affect the conductive paste of the present embodiment. When the first glass frit contains $V_2O_5$, the content of $V_2O_5$ in the first glass frit (100 mol%) is preferably less than 8 mol% and more preferably 5 mol% or less. When the first glass frit contains $V_2O_5$, the basicity of the first glass frit can be lowered. Therefore, when the basicity of the first glass frit is high, the basicity of the first glass frit can be adjusted to an appropriate range by including an appropriate amount of $V_2O_5$.

The first glass frit can contain $TeO_2$ within a range that does not adversely affect the conductive paste of the present embodiment. When the first glass frit contains $TeO_2$, the content of $TeO_2$ in the first glass frit (100 mol%) is preferably less than 80 mol%, and more preferably 50 mol% or less. When the first glass frit contains $TeO_2$, the basicity of the first glass frit can be lowered. Therefore, when the basicity of the first glass frit is high, the basicity of the first glass frit can be adjusted to an appropriate range by including an appropriate amount of $TeO_2$.

The first glass frit can contain BaO within a range that does not adversely affect the conductive paste of the present embodiment. When the first glass frit contains BaO, the content of BaO in the first glass frit (100 mol%) is preferably 3 to 20 mol%, and more preferably 5 to 10 mol%. When the first glass frit contains an appropriate amount of BaO, the reactivity to the passivation film 2 can be adjusted to an appropriate range.

The first glass frit can contain CuO within a range that does not adversely affect the conductive paste of the present embodiment. When the first glass frit contains CuO, the content of CuO in the first glass frit (100 mol%) is preferably 10 to 40 mol%, more preferably 20 to 30 mol%. When the first glass frit contains an appropriate amount of CuO, the reactivity to the passivation film 2 can be adjusted to an appropriate range.

The first glass frit can contain $Li_2O$ within a range that does not adversely affect the conductive paste of the present embodiment. When the first glass frit contains $Li_2O$, the content of $Li_2O$ in the first glass frit (100 mol%) is preferably 3 to 40 mol%, more preferably 5 to 30 mol%. When the first glass frit contains an appropriate amount of $Li_2O$, the reactivity to the passivation film 2 can be adjusted to an appropriate range.

The first glass frit may contain ZnO within a range that does not adversely affect the conductive paste of the present embodiment. When the first glass frit contains ZnO, the content of ZnO in the first glass frit (100 mol%) is preferably 5 to 70 mol% and more preferably 15 to 60 mol%. By including ZnO in the first glass frit, the basicity of the first glass frit can be adjusted to an appropriate range.

The first glass frit included in the conductive paste of the present embodiment is preferably lead-free glass frit. In this case, the first glass frit included in the conductive paste of the present embodiment does not substantially contain lead (Pb). However, the lead-free first glass frit used in the present embodiment can contain a small amount of lead which is inevitably mixed as an impurity. Specifically, the lead-free first glass frit used in the present embodiment can contain 0.1 weight % or less of lead as an impurity. By using the conductive paste containing the lead-free first glass frit to produce a solar cell, lead contamination to the environment can be prevented when the solar cell is disposed of.

Next, the second glass frit will be described. The second glass frit is a glass frit containing PbO.

The second glass frit contained in the conductive paste of the present embodiment preferably contains one or more selected from PbO, $SiO_2$, $Al_2O_3$, $B_2O_3$, ZnO, $V_2O_5$, $WO_3$ and $Nb_2O_3$. The second glass frit contained in the conductive paste of the present embodiment more preferably contains PbO, $SiO_2$, $Al_2O_3$, $B_2O_3$ and ZnO.

In the conductive paste of the present embodiment, the second glass frit preferably contains at least one selected from ZnO, $V_2O_5$, $WO_3$ and $Nb_2O_3$. When the second glass frit contains at least one of these oxides, the basicity of the second glass frit can be adjusted to an appropriate range.

The second glass frit preferably contains PbO. The content of PbO in the second glass frit (100 mol%) is preferably 25 to 60 mol%, more preferably 30 to 55 mol%, and further more preferably 40 to 55 mol%. By including PbO in the second glass frit, the reactivity to the passivation film 2 can be suppressed and the contact resistance can be reduced.

The second glass frit preferably contains $SiO_2$. The content of $SiO_2$ in the second glass frit (100 mol%) is preferably 20 to 65 mol%, more preferably 25 to 60 mol%. By including $SiO_2$ in the second glass frit, the reactivity to the passivation film 2 can be suppressed.

The second glass frit preferably contains $Al_2O_3$. The content of $Al_2O_3$ in the second glass frit (100 mol%) is preferably 3.0 to 6.8 mol%, more preferably 3.5 to 6 mol%. By including $Al_2O_3$ in the second glass frit, the reactivity to the passivation film 2 can be suppressed.

The second glass frit preferably contains $B_2O_3$. The content of $B_2O_3$ in the second glass frit (100 mol%) is preferably 3.0 to 15 mol%, more preferably 3.5 to 12 mol%.

The second glass frit preferably contains ZnO. The content of ZnO in the second glass frit (100 mol%) is preferably 5 to 20 mol%, more preferably 8 to 15 mol%. When the second glass frit contains ZnO, the basicity of the second glass frit can be adjusted to an appropriate range.

In the conductive paste of the present embodiment, the product $C_{PbO} \cdot G$ of a content $C_{PbO}$ of PbO in the second glass frit and a content G of the second glass frit is preferably in the range of 20 to 139, more preferably in the range of 22 to 130, and further more preferably in the range of 26 to 105. When the product $C_{PbO} \cdot G$ exceeds 139, the reactivity between the second glass frit and the passivation film 2 becomes too high. When the product $C_{PbO} \cdot G$ is less than 20, the contact resistance between an obtained electrode and the impurity diffusion layer 4 becomes too high.

In the first and second glass frits, the particles of the glass frit may be one type of particles each containing a predetermined amount of a required plurality of oxides. In addition, the particles composed of a single oxide may be used as different particles for each required plurality of oxides. In addition, the particles of a plurality of types having different compositions of the required plurality of oxides may be used in combination. In order to synergistically obtain the effects of the different types of oxides, it is preferable that the particles of the first and second glass frits are one type of particles each containing a predetermined amount of a required plurality of oxides.

<Other Ingredients>

The conductive paste of the present embodiment can contain additives and additive materials other than those described above within a range that does not adversely affect the solar cell characteristics of the obtained solar cell.

In the conductive paste of the present embodiment, additives selected from plasticizers, antifoaming agents, dispersants, leveling agents, stabilizers, adhesion promoters, and the like can be further incorporated as required. Among these, as the plasticizers, at least one selected from phthalic esters, glycolic esters, phosphoric esters, sebatic esters, adipic esters, citric esters, and the like can be used.

The conductive paste of the present embodiment can contain additives other than those described above within a range that does not adversely affect the solar cell characteristics of the obtained solar cell. For example, the conductive paste of the present embodiment may further include at least one additive selected from titanium resinate, titanium oxide, cobalt oxide, cerium oxide, silicon nitride, copper manganese tin, aluminosilicate, and aluminum silicate. The inclusion of these additives may improve the adhesion strength of the electrode to the passivation film 2. These additives may be in the form of particles (additive particles). The amount of additive added to the silver particles 100 parts by weight is preferably 0.01 to 5 parts by weight, more preferably 0.05 to 2 parts by weight. In order to obtain higher adhesion strength, the additive is preferably copper manganese tin, aluminosilicate or aluminum silicate. The additive may include both aluminosilicate and aluminum silicate.

<Production Method of Conductive Paste>

Next, a method for producing the conductive paste of the present embodiment will be described. The conductive paste of the present embodiment may be produced by adding, mixing, and dispersing silver particles, glass frit, and, if necessary, other additives and/or additive materials to an organic binder and a solvent.

Mixing can be performed by, for example, a planetary mixer. Dispersion can be performed by a three-roll mill. Mixing and dispersion are not limited to these methods, and various known methods can be used.

EXAMPLE

Hereinafter, the present embodiment will be specifically described with reference to Examples, but the present invention is not limited thereto.

<Solar Cells of Examples 1 to 7 and Comparative Examples 1 and 2>

In the Examples and Comparative Examples, single crystalline silicon solar cells were fabricated, and the performances of the solar cells of the Examples and Comparative Examples were evaluated by measuring the electrical characteristics of the single crystalline silicon solar cells.

<<Materials and Preparation Ratio of Conductive Pastes>>

Tables 1 and 2 show the compositions of conductive particles (A) and glass frits (C) in the conductive pastes of the Examples and Comparative Examples. The compositions of conductive particles (A) and glass frits (C) in the conductive pastes of the Examples and Comparative Examples are shown as parts by weight when conductive particles (A) are 100 parts by weight. The components in the conductive paste are as follows.

Silver particle (A)

Table 3 shows part numbers, manufacturers, shape, average particle size (D50), TAP density, and BET specific surface area of silver particles A1 and A2 used in the conductive pastes of Examples and Comparative Examples. Tables 1 and 2 show the amount of the silver particles A1 and A2 used in the conductive pastes of Examples and Comparative Examples. The average particle size (D50) was determined by measuring of particle size distribution by the micro-track method (laser diffraction scattering method) and obtaining the value of the median diameter (D50) from the result of the measurement of particle size distribution. The same applies to the average particle size (D50) of the other components. For the measurement of BET specific surface area, a full-automatic specific surface area measuring device Macsoeb (manufactured by MOUNTEC) was used. The BET specific surface area was measured by BET one point method using nitrogen gas adsorption after pre-drying at 100 degree C and flowing nitrogen gas for 10 minutes.

Organic vehicle (B)

Organic binder and solvent were used as the organic vehicle. Ethylcellulose (0.4 parts by weight) having an ethoxy content of 48 to 49.5 weight % was used as the organic binder. Diethylene glycol monobutyl ether acetate (butyl carbitol acetate) (3 parts by weight) was used as the solvent.

Glass frit (C)

Table 4 shows the composition, basicity, and glass transition temperature of the glass frits GF1 to GF6 used for the conductive pastes of the Examples and Comparative Examples. The average particle size (D50) of the glass frits GF1 to GF6 was 2 $\mu$m. Tables 1 and 2 show the types of the glass frits (C) and the contents G (parts by weight) of the glass frits in the conductive paste of the Examples and Comparative Examples.

The glass transition temperatures of the glass frits GF1 to GF6 were measured. Table 4 shows the measured values of the glass transition temperatures of the glass frits GF1 to GF6. The glass transition temperatures of the glass frits were measured as follows. Approximately 50 mg of glass frits GF1 to GF6 were placed in a platinum cell as samples, and alumina powder was used as a standard sample, and a DTA curve was obtained at a temperature increase rate of 20 degree C/minute from room temperature to 800 degree C under air atmosphere using a differential thermal analyzer (Made by Rigaku Corporation, TG-8120). The starting point of the first endotherm (extrapolation point) of the DTA curve was set as the glass transition temperature.

Glass frits GF1 to GF6 were produced as follows. First, oxide powder as a raw material was weighed, mixed, and charged into a crucible. The crucible was placed in a heated oven, and the contents of the crucible were heated up to the melt temperature and maintained at the melt temperature until the raw material was sufficiently melted. Next, the crucible was removed from the oven, and the melted contents were stirred uniformly. Next, the contents of the crucible were quenched at room temperature using two stainless steel rolls to obtain plate-like glass. Finally, the plate-like glass was uniformly dispersed by grinding with a mortar, and the glass frit with the desired grain size was obtained by sieving with a mesh sieve. A glass frit with an average particle size (D50) of 149 $\mu$m was obtained by sieving through a 100 mesh sieve and into those remaining on a 200 mesh sieve. By further grinding the glass frit, a glass frit with an average particle size (D50) of 2 $\mu$m was obtained.

Next, the conducting particles (A), the organic vehicle (B), and the glass frit (C) of the predetermined type and amount described above were mixed with a planetary mixer, dispersed with a three-roll mill, and made into a paste to produce the conductive pastes of Examples and Comparative Examples.


<<Production of Single Crystalline Silicon Solar Cell>>

Single crystalline silicon solar cells of bifacial light receiving type as shown in Fig. 4 were produced. As the substrates, P (phosphorus) -doped n-type single crystalline silicon substrates (substrate thickness 200 $\mu$m) were used.

First, a silicon oxide layer of about 20 $\mu$m was formed on the substrate by dry oxidation, and then it was etched with a mixed solution of hydrogen fluoride, pure water, and ammonium fluoride to remove the damage on the substrate surface. Then, heavy metal cleaning was performed with an aqueous solution containing hydrochloric acid and hydrogen peroxide.

Next, texture (uneven shape) was formed on both surfaces of the substrate by wet etching. Specifically, a pyramid-like texture structure was formed on both surfaces (the main light incident side surface and the back surface) by wet etching (sodium hydroxide aqueous solution). Then, the substrate was cleaned with an aqueous solution containing hydrochloric acid and hydrogen peroxide.

Then, boron was implanted into one surface (the light incident side surface) of the substrate having the texture structure to form a p-type diffusion layer with a depth of about 0.5 $\mu$m. The sheet resistance of the p-type diffusion layer was 150 $\Omega/\square$.

Phosphorus was implanted into the other surface (the back surface) of the substrate having the texture structure to form an n-type diffusion layer with a depth of about 0.5 $\mu$m. The sheet resistance of the n-type diffusion layer was 20 $\Omega/\square$. Boron and phosphorus were implanted simultaneously by thermal diffusion method.

Next, a passivation films 2 was formed on the surface (the light incident side surface) of the substrate, on which the p-type diffusion layer was formed, and on the surface (the back surface) of the substrate, on which the n-type diffusion layer was formed. Specifically, thin oxide layers of 1 to 2 nm were formed on the light incident side surface and on the back surface, and then silicon nitride films with a thickness of about 60 nm were formed using silane gas and ammonia gas by the plasma CVD method. Specifically, silicon nitride films (antireflection films) with a thickness of about 70 nm were formed by the plasma CVD method by glow discharge decomposition of a gas mixture of $NH_3$ / $SiH_4$ = 0.5 at 1 Torr (133 Pa).

The conductive pastes for electrode formation on the surface (the light incident side surface) of the substrate on which the p-type diffusion layer was formed in the single crystalline silicon solar cell of the Examples and the Comparative Examples were used with the contents shown in Tables 1 and 2.

The conductive paste was printed by the screen printing method. A pattern consisting of a light incident side bus bar electrode 20a of 1.5 mm width and a light incident side finger electrode 20b of 60 $\mu$m width was printed on the passivation film 2 of the above-described substrate so that the film thickness was about 20 $\mu$m, and then dried at 150 degree C for about 1 minute.

The same Ag paste was printed as a back side electrode 15 (an electrode on the surface on which the n-type diffusion layer was formed) by the screen printing method. The electrode pattern of the back side electrode 15 was the same as that of the light incident side surface-electrode 20. Then, it was dried at 150 degree C for about 60 seconds. The thickness of the conductive paste for the back side electrode 15b after drying was about 20 $\mu$m. Thereafter, both surfaces were simultaneously fired at a peak temperature of 720 degree C and in-out time of the firing furnace of 50 seconds using a belt furnace (a firing furnace) CDF7210 manufactured by Despatch Industries, Inc. The single crystalline silicon solar cells were prepared as described above.

<<Laser Treatment Process>>

The AgSi region 30 was formed by performing the laser treatment process on the light incident side surface of the single crystalline silicon solar cell of the above Examples and Comparative Examples. Namely, a negative voltage was applied to the back side electrode 15 and a positive voltage was applied to the light incident side surface-electrode 20 of the pattern shown in Fig. 2, which was formed on the light incident side surface, with irradiating laser light to the light incident side surface of the solar cell, so that a current flows in the opposite direction from the forward direction between the p-type impurity diffusion layer 4 and the n-type crystalline silicon substrate 1 of the solar cell. During the laser treatment process, the applied voltage was 20 V, the intensity of the irradiated laser light was 100 W/cm$^2$, and the application of the voltage and the irradiation time of the laser light were 2 seconds.

The solar cells of the Examples and Comparative Examples were produced as described above.

<Measurement of Electrical Properties of Solar Cells after Laser Treatment Process>

The electrical characteristics of the single crystalline silicon solar cells after the laser treatment process were measured as follows. Namely, the current-voltage characteristics of the experimentally produced solar cells were measured under the irradiation of solar simulator light (energy density 100 mW/cm$^2$) at 25 degree C and AM1.5 using the SS-150XIL solar simulator manufactured by EKO Instruments Co., Ltd., and fill factor (FF), open circuit voltage (Voc), and conversion efficiency (%) were calculated from the measurement results. Two single crystalline silicon solar cells were produced under the same manufacturing condition, and the measured values were obtained as the average of the two. The electrical characteristics (fill factor (FF), open circuit voltage (Voc), and conversion efficiency (%)) of the solar cells after the laser treatment process were measured. Tables 1 and 2 show the measurement results.

It is clear from Table 1 that the solar cells of Examples 1 to 7 prepared using the predetermined conductive paste had high electrical characteristics after the laser treatment process, for example, conversion efficiency ranged from 21.3% to 24.4%. In contrast, the solar cells prepared using the conductive paste of Comparative Example 1 had low electrical characteristics after the laser treatment process, for example, conversion efficiency ranged from 7.3 to 20.2. Therefore, it is clear that the solar cells of Examples 1 to 7 in the present embodiment with the predetermined AgSi region 30 had better electrical characteristics after the laser treatment process than the solar cells of Comparative Examples 1 and 2.

<SEM Photograph>

The cross-sections near the passivation film 2 (the antireflection film) of the solar cells of Examples and Comparative Examples were observed by scanning electron microscope (SEM). Figs. 6 and 7 are the cross-sectional SEM photographs of the solar cells of Example 3. Fig. 8 is a cross-sectional SEM photograph of the solar cell of Comparative Example 1.

When the laser treatment process is used, a passivation film 2 (an antireflection film) exists in the major portion between the light incident side surface-electrode 20 and the impurity diffusion layer 4. In the laser treatment process, the predetermined voltage described above is applied so that a current flows in the opposite direction from the forward direction at the p-n junction, and light from a point light source (e.g., laser light) is irradiated, so that a current flows in a small area between the light incident side surface-electrode 20 and the impurity diffusion layer 4, and it is locally heated. As the result, as shown in Figs. 6 and 7, an AgSi region 30 (silver and silicon alloy), which is a local conductive portion, is formed between the light incident side surface-electrode 20 and the impurity diffusion layer 4. That is, the local conductive portion includes a silver and silicon alloy. In the local conductive portion, the impurity diffusion layer 4 (the second conductivity type silicon emitter layer) directly contacts the light incident side surface-electrode 20 without passing through the passivation film 2 (the antireflection film). This locally formed electrical conductive portion allows good electrical conduction between the light incident side surface-electrode 20 and the impurity diffusion layer 4. The predetermined conductive paste for producing the solar cell of the present embodiment has a low reactivity to the passivation film 2 (the antireflection film) and an appropriate reactivity with the passivation film 2 (the antireflection film) for the laser treatment process. Therefore, the conductive paste of the present embodiment can be preferably used to form the light incident side surface-electrode 20 of crystalline silicon solar cell using the laser treatment process.

<Depth d of AgSi Region 30>

The depth d of AgSi region 30 in Examples 1 to 7 and Comparative Examples 1 and 2 was measured as follows. Tables 1 and 2 show the measurement results.

Fig. 6 shows an example of the depth d of AgSi region 30. The depth d of AgSi region 30 was measured as the length (Length d of the line segment connecting B1 and B2 in Fig. 6) of the line segment that is the maximum length among the line segments connecting an arbitrary point (B1 in Fig. 6) at the interface between the electrode and AgSi region 30 to an arbitrary point (B2 in Fig. 6) at the interface between the substrate and AgSi region 30 in the SEM photograph in which the cross-section of AgSi region 30 was observed by SEM. The SEM photograph shown in Fig. 6 was obtained by SEM observation of the cross-section including the passivation film 2 and the AgSi region 30 of the completed solar cell at a magnification of 20,000 times.

<Remaining Ratio of Passivation Film 2>

The remaining ratio of passivation film 2 in Examples 1 to 7 and Comparative Examples 1 and 2 was measured as follows. Tables 1 and 2 show the measurement results.

Specifically, first, SEM photographs (SEM image range: 5.7 $\mu$m $\times$ 3.9 $\mu$m) were obtained by SEM observation of a cross-section including a passivation film 2 and AgSi region 30 of a completed solar cell at a magnification of 20,000 times. The length of the SEM photograph in the horizontal direction (in the horizontal direction with the substrate surface) is 5.7 $\mu$m, and the length of the SEM photograph in the vertical direction (in the vertical direction with the substrate surface) is 3.9 $\mu$m. Next, as illustrated in Fig. 7, the total length Lp of the cross-section of passivation film 2 in the SEM photograph was measured. In the example shown in Fig. 7, the total length Lp of the cross-section of the passivation film 2 in the SEM photograph is the total length of Lp1, Lp2, Lp3 and Lp4. Next, in the SEM photograph, the total length Le of the cross-section of the interface between the AgSi region 30 and the electrode at the part where the AgSi region 30 was generated was measured. The length Le corresponds to the length of a passivation film 2 lost in the manufacturing process of a solar cell. In the example shown in Fig. 7, the total length Le of the cross-section of the interface between the AgSi region 30 and the electrode at the part where passivation film 2 was lost is the total length of Le1 and Le2. The remaining ratio of passivation film 2 can be obtained as Lp / (Lp + Le). The length of Lp1, etc. was measured by approximating that passivation film 2, etc. is a straight line.

<Film Thickness and Film Thickness Ratio of Passivation Film 2 before and after Firing>

A film thickness Da before firing of a passivation film 2 and the film thickness Db after completion of a solar cell were measured for the solar cells of Examples 1 to 7 and Comparative Examples 1 and 2. Tables 1 and 2 show the measurement results. Tables 1 and 2 show the film thickness ratio of passivation film 2 before and after firing.

The film thickness Da before firing of a passivation film 2 was measured by SEM observation of a cross-section of the passivation film 2 immediately after the film formation. Namely, the film thickness Da before firing of a passivation film 2 in Examples and Comparative Examples was obtained by forming the passivation film 2 on a surface of a silicon substrate 1 under the same conditions as in Examples and Comparative Examples, and performing SEM observation of the cross-section of the passivation film 2.

The film thickness Db after completion of the solar cell is the passivation film 2 of a completed solar cell after an electrode is formed on a surface of the solar cell and the prescribed laser treatment process is performed as necessary. Specifically, first, a SEM photograph (SEM image range: 5.7 $\mu$m $\times$ 3.9 $\mu$m) was obtained by SEM observation of a cross-section including a passivation film 2 and AgSi region 30 of a completed solar cell at a magnification of 20,000 times. Next, the SEM photographs were vertically divided into 6 equal sections, and the film thicknesses of the passivation film 2 at 5 boundaries (5 portions) of the 6 equal sections were measured. The film thickness Db after completion of the solar cell was taken as the average value of the film thicknesses of the 5 portions of the passivation film 2.

The film thickness ratio before and after firing of the passivation film 2 is the ratio (Db / Da) of the film thickness Da of the passivation film 2 before firing and the film thickness Db of the passivation film 2 after completion of the solar cell measured as described above.

<Evaluation>

As shown in Tables 1 and 2, in the solar cells of Examples 1 to 7, the depth d of the AgSi region 30 determined from the cross-section SEM photograph was in the range of 200 to 1800 nm. In the solar cells of Examples 1 to 7, it was confirmed that the predetermined AgSi region 30 was formed. In the solar cells of Examples 1 to 7, the thickness ratio of the passivation film 2 before and after firing was in the range of 17 to 78%, and the remaining ratio of the passivation film 2 was in the range of 10 to 90%. Therefore, it was confirmed that the predetermined passivation film 2 was remained after the manufacture of the solar cells of Examples 1 to 7 produced by the predetermined firing and laser treatment process. As a result, the electrical characteristics after the laser treatment process of the solar cells of Examples 1 to 7 produced by the conductive paste containing the glass frit of GF1 to 3, GF5 and GF6 were high, for example, the conversion efficiency ranged from 21.3% to 24.4%. In the solar cells of Examples 1 to 7, the open circuit voltage (Voc) was high and in the range of 0.69 to 0.72 V because the passivation film 2 having the predetermined passivation function remained. The fill factor (FF) of the solar cells of Examples 1 to 7 was in the range of 72.7 to 82.6%, which was a good value.

The remaining ratio of the passivation film 2 remaining in the solar cells of Examples 1 to 5 was in the range of 76 to 88%, and the conversion efficiency ranged from 23.4% to 24.4%. That is, the conversion efficiency of the solar cell of Examples 1 to 5 was higher than that of the solar cell of Example 6 (10% of passivation film 2 remaining) and the solar cell of Example 7 (90% of passivation film 2 remaining). Therefore, when the remaining ratio of the passivation film 2 is 30% or more and less than 90%, a solar cell of higher conversion efficiency can be obtained.

In the solar cells of Examples 1 to 5, the thickness ratio of passivation film 2 before and after firing ranged from 36 to 51%, and the conversion efficiency ranged from 23.4% to 24.4%. That is, the conversion efficiency of the solar cells of Examples 1 to 5 was higher than that of the solar cell of Example 6 (78% of the thickness ratio) and Example 7 (17% of the thickness ratio). Therefore, when the thickness ratio of the passivation film 2 before and after firing is 20 to 70%, it can be said that a solar cell with higher conversion efficiency can be obtained.

On the other hand, as shown in Table 2, in the solar cell of Comparative Example 1, AgSi region 30 was not observed from the SEM photograph of the cross-section. In the solar cell of Comparative Example 1, the thickness ratio of the passivation film 2 before and after firing was 91%, and the remaining ratio of the passivation film 2 was 100%. Therefore, in the solar cell of Comparative Example 1 produced by performing the predetermined firing and laser treatment process, it was confirmed that the predetermined passivation film 2 remained almost the same as immediately after the film formation, and that AgSi region was not formed. Thus, the electrical characteristics of the solar cell produced by using conductive paste containing GF4 glass frit after laser treatment process were low, for example, the conversion efficiency was 7.3%. In particular, in the solar cell of Comparative Example 1, the fill factor (FF) was as low as 35.7% because the passivation film 2, which is an insulating film, remained.

In the solar cell of Comparative Example 2, AgSi region 30 was observed in the cross-sectional SEM photograph. As shown in Table 2, in the solar cell of Comparative Example 2, the depth d of the AgSi region 30 obtained from the cross-sectional SEM photograph was 1200 nm. In the solar cell of Comparative Example 2, the thickness ratio of the passivation film 2 before and after firing was 5%, and the remaining ratio of the passivation film 2 was 5%. Therefore, it became clear that the existence of the passivation film 2 was less in the solar cell of Comparative Example 2 produced by the predetermined firing and laser treatment process compared to the solar cells of Examples 1 to 7. As a result, the conversion efficiency after the laser treatment process of the solar cell of Comparative Example 2 produced using the conductive paste containing GF3 glass frit was 20.2%, which was lower compared to the solar cells of Examples 1 to 7. In the solar cell of Comparative Example 2, the existence of the passivation film 2 was less and the passivation function was lowered, so the open circuit voltage (Voc) was 0.64 V, which was a low value. In the solar cell of Comparative Example 2, it is considered that the passivation film 2 was fired through when the electrode formed by the conductive paste containing GF3 glass frit was fired.

In addition, the solar cells of Examples 1, 2 and 4 to 7 were produced using the conductive pastes containing lead-free glass frits (GF1 to GF5 glass frits), which prevents lead contamination to the environment when the solar cell is disposed of.

[Table 1]

| (Content is parts by weight) | | Example 1 | Example 2 | Example 3 | Example 4 | Example 5 |
|---|---|---|---|---|---|---|
| Conductive particles (A) (Content) | Conductive particles A1 | 100 | | 100 | 100 | 100 |
| | Conductive particles A2 | | 100 | | | |
| Glass frit (C) | Type | GF1 | GF1 | GF6 | GF2 | GF5 |
| | Content G | 1 | 1 | 1 | 1 | 2.5 |
| Basicity $\times$ (C) Content G | | 0.34 | 0.34 | 0.68 | 0.39 | 0.60 |
| $C_{Bi2O3}$ $\times$ (C) Content G | | 35 | 35 | 51 | 65 | 58 |
| Depth of AgSi region (nm) | | 500 | 400 | 1800 | 200 | 1000 |

(continued)

| (Content is parts by weight) | | Example 1 | Example 2 | Example 3 | Example 4 | Example 5 |
|---|---|---|---|---|---|---|
| Evaluation of passivation film | Film thickness before firing (Da) (nm) | 180 | 180 | 180 | 180 | 180 |
| | Film thickness after firing and treatment (Db) (nm) | 90 | 92 | 76 | 64 | 64 |
| | Film thickness ratio (Db/Da) | 50% | 51% | 42% | 36% | 36% |
| | Remaining ratio | 81% | 85% | 82% | 88% | 76% |
| After laser treatment process | FF (%) | 81.4 | 81.6 | 82.1 | 80.8 | 82.6 |
| | Voc(V) | 0.71 | 0.71 | 0.72 | 0.71 | 0.72 |
| | Conversion efficiency (%) | 24.2 | 24.0 | 24.2 | 23.4 | 24.4 |

[Table 2]

| (Content is parts by weight) | | Example 6 | Comparative Example 1 | Example 7 | Comparative Example 2 |
|---|---|---|---|---|---|
| Conductive particles (A) (Content) | Conductive particles A1 | 100 | 100 | 100 | 100 |
| | Conductive particles A2 | | | | |
| Glass frit (C) | Type | GF1 | GF4 | GF3 | GF3 |
| | Content G | 0.74 | 1.0 | 1.4 | 2.0 |
| Basicity $\times$ (C) Content G | | 0.25 | 0.11 | 1.43 | 2.04 |
| $C_{Bi2O3} \times$ (C) Content G | | 26 | 0 | 34 | 48 |
| Depth of AgSi region (nm) | | 200 | 0 | 1000 | 1200 |
| Evaluation of passivation film | Film thickness before firing (Da) (nm) | 180 | 180 | 180 | 180 |
| | Film thickness after firing and treatment (Db) (nm) | 140 | 164 | 30 | 9 |
| | Film thickness ratio (Db/Da) | 78% | 91% | 17% | 5% |
| | Remaining ratio | 90% | 100% | 10% | 5% |
| After laser treatment process | FF (%) | 72.7 | 35.7 | 78.4 | 79.0 |
| | Voc(V) | 0.72 | 0.7 | 0.69 | 0.64 |
| | Conversion efficiency (%) | 21.3 | 7.3 | 22.3 | 20.2 |

[Table 3]

| | Part number | Manufacturer | Shape | average particle size D:50($\mu$m) | TAP density (g/cm$^3$) | BET specific surface area (m$^2$/g) |
|---|---|---|---|---|---|---|
| Silver particles A1 | AG-SNA-190 | DOWA Electronics | Spherical | 2 | 5 | 0.4 |
| Silver particles A2 | AG-SNA-188 | DOWA Electronics | Spherical | 1 | 5 | 1.0 |

[Table 4]

| (Content (mol%)) | GF1 | GF2 | GF3 | GF4 | GF5 | GF6 |
|---|---|---|---|---|---|---|
| PbO | | | | | | 51.0 |
| $SiO_2$ | 17.0 | 30.0 | | | 24.0 | 31.0 |
| $Al_2O_3$ | | | | | | 4.0 |
| $B_2O_3$ | 41.0 | 5.0 | | | 35.0 | 4.0 |
| $V_2O_5$ | | | | 8.0 | | |
| $Bi_2O_3$ | 35.0 | 65.0 | 24.0 | | 23.0 | |
| $TeO_2$ | | | | 92.0 | | |
| $Li_2O$ | 7.0 | | 27.0 | | | |
| ZnO | | | 49.0 | | 18.0 | 10.0 |
| Total (mol%) | 100.0 | 100.0 | 100.0 | 100.0 | 100.0 | 100.0 |
| Basicity $B_{GF}$ | 0.34 | 0.39 | 1.02 | 0.11 | 0.24 | 0.24 |
| Glass transition temperature (degree C) | 375 | 364 | Indistinct | 270 | 459 | 459 |

Description of Reference Numerals

1: Crystalline silicon substrate

2: Passivation film

4: Impurity diffusion layer

6: Substrate main body

14: Back side passivation film

15: Back side electrode

15a: Back side TAB electrode (Back side bus bar electrode)

15b: Back side full-surface electrode

15c: Back side finger electrode

16: Second impurity diffusion layer

20: Light incident side surface-electrode (Front surface electrode)

20a: Light incident side bus bar electrode

20b: Light incident side finger electrode

22: Electrode pattern

30: AgSi region

**Claims**

1.  A solar cell comprising:

    a substrate comprising crystalline silicon, the substrate comprising an impurity diffusion layer on at least one surface;
    a passivation film disposed on at least a part of the impurity diffusion layer of the substrate; and
    an electrode comprising silver (Ag), the electrode disposed on at least a part of the passivation film, wherein:

    the solar cell further comprises at least one AgSi region disposed in at least a portion between the electrode and the substrate;
    the AgSi region comprises at least one AgSi region having a depth of 100 nm or more;
    a remaining ratio of the passivation film, which is a ratio of a length of the passivation film remaining in a scanning electron microscope photograph of a $5.7~\mu m \times 3.9~\mu m$ cross-section comprising the AgSi region of the solar cell, is 10 to 90%.

2.  The solar cell according to claim 1, wherein a ratio Db / Da between a film thickness Da of the passivation film immediately after deposition and a film thickness Db of the passivation film in a scanning electron microscope photograph of a $5.7~\mu m \times 3.9~\mu m$ cross-section comprising the AgSi region of the solar cell completed by forming the electrode on the surface of the solar cell, is 15% to 85%.

3.  The solar cell according to claim 1 or 2, wherein the electrode further comprises 0.1 to 5.0 parts by weight of glass frit relative to 100 parts by weight of the silver (Ag) contained in the electrode.

4.  The solar cell according to claim 3, wherein the glass transition temperature of the glass frit is 250 to 600 degree C.

5.  The solar cell according to claim 3 or 4, wherein the glass frit comprises at least one selected from $SiO_2$, $B_2O_3$, $V_2O_5$, $Bi_2O_3$, $TeO_2$, $Li_2O$ and ZnO.

6.  The solar cell according to any one of claims 3 to 5, wherein the glass frit does not comprise substantially PbO.

7.  The solar cell according to any one of claims 1 to 6, wherein the electrode does not comprise substantially lead (Pb).

8.  The solar cell according to any one of claims 1 to 7, wherein the electrode does not comprise substantially aluminum particles.

9.  The solar cell according to any one of claims 1 to 8, wherein

    the substrate is a crystalline silicon substrate of a first conductivity type,
    the impurity diffusion layer is an impurity diffusion layer of a second conductivity type,
    the electrode is a light incident side surface-electrode disposed on a light incident side surface,
    the solar cell further comprising a back side electrode disposed so as to be electrically connected to a surface opposite to the light incident side surface of the crystalline silicon substrate,
    the light incident side surface-electrode is a light incident side surface-electrode that is processed to irradiate light from a point light source to the light incident side surface of the solar cell, while applying a voltage between the back side electrode and the light incident side surface-electrode such that an electric current flows between the impurity diffusion layer of the second conductivity type and the semiconductor substrate of the first conductivity type in a direction opposite to the forward bias direction.

Fig. 1

20, 20b

30

2

4

1

6

16

15, 15b

Fig. 2

20

20b    20a

2

Fig. 3

Fig. 4

Fig. 5

Fig. 6

Fig. 7

Fig. 8

## INTERNATIONAL SEARCH REPORT

| International application No. |
| --- |
| **PCT/JP2023/029078** |

**A. CLASSIFICATION OF SUBJECT MATTER**

*H01L 31/0224*(2006.01)i; *H01B 1/22*(2006.01)i
FI: H01L31/04 264; H01B1/22 A

According to International Patent Classification (IPC) or to both national classification and IPC

**B. FIELDS SEARCHED**

Minimum documentation searched (classification system followed by classification symbols)

H01L31/00-31/078

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2014-78594 A (NORITAKE CO., LTD.) 01 May 2014 (2014-05-01)<br>entire text, all drawings | 1-9 |
| A | JP 2015-50277 A (SHARP KABUSHIKI KAISHA) 16 March 2015 (2015-03-16)<br>entire text, all drawings | 1-9 |
| A | JP 2014-150015 A (NAMICS CO.) 21 August 2014 (2014-08-21)<br>entire text, all drawings | 1-9 |
| A | US 2011/0278507 A1 (E. I. DU PONT DE NEMOURS AND CO.) 17 November 2011 (2011-11-17)<br>entire text, all drawings | 1-9 |

☐ Further documents are listed in the continuation of Box C.  ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **12 September 2023** | **03 October 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2023/029078**

| Patent document cited in search report | | | Publication date (day/month/year) | Patent family member(s) | Publication date (day/month/year) |
|---|---|---|---|---|---|
| JP | 2014-78594 | A | 01 May 2014 | (Family: none) | |
| JP | 2015-50277 | A | 16 March 2015 | (Family: none) | |
| JP | 2014-150015 | A | 21 August 2014 | (Family: none) | |
| US | 2011/0278507 | A1 | 17 November 2011 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011086754 A
- JP 2021513218 A
- JP 2009231826 A

**Non-patent literature cited in the description**

- **K. MORINAGA** ; **H. YOSHIDA** ; **H. TAKEBE**. *J. AmCerm. Soc.*, 1994, vol. 77, 3113